# EUROPEAN PATENT APPLICATION

(11) **EP 4 669 075 A1**
(43) Date of publication of application: **24.12.2025**
(21) Application number: 25183283.8
(22) Date of filing: 17.06.2025
(51) Int. Cl.: H10K 59/122, H10K 59/124, H10K 59/131, H10K 59/80, H10K 77/10, H10K 102/00

(54) **DISPLAY DEVICE AND ELECTRONIC DEVICE INCLUDING THE SAME**

(30) Priority: 20.06.2024 KR 20240080331; 01.08.2024 KR 20240102362
(71) Applicant: Samsung Display Co., Ltd., Yongin-si, Gyeonggi-do 17113 (KR)
(72) Inventor: LEE, Dong Hyun, 17113 Yongin-si (KR); KANG, Youn Woong, 17113 Yongin-si (KR); SONG, Sang Hyeon, 17113 Yongin-si (KR); SONG, Si Joon, 17113 Yongin-si (KR); IM, Dae Hyuk, 17113 Yongin-si (KR)
(74) Representative: Marks & Clerk LLP

(57) **Abstract**

A display device may include: a base layer including an organic material, the base layer in which a first area, a bending area continued to the first area, and a second area continued to the bending area are defined; a barrier layer disposed on the base layer in each of the first area and the second area; a substrate disposed on the barrier layer, the substrate including an organic material; a pixel circuit layer disposed on the substrate in the first area and the second area, the pixel circuit layer being disposed on the base layer in the bending area; and a display element layer disposed on the pixel circuit layer. The pixel circuit layer may be disposed directly on one surface of the base layer in the bending area.

## Description

### BACKGROUND

### 1. Technical Field

Embodiments of the present disclosure generally relate to a display device and an electronic device including the display device.

### 2. Description of the Related Art

Recently, as interest in information displays has increased, research and development of display devices have been continuously conducted.

### SUMMARY

Embodiments of the present disclosure provide a display device capable of reducing or preventing cracks of a connection line due to stress which may occur in (or during) bending while reducing a dead space.

A display device according to one or more embodiments includes a base layer including an organic material, in which a first area, a bending area continued to the first area, and a second area continued to the bending area are defined in the base layer; a barrier layer on the base layer in each of the first area and the second area; a substrate on the barrier layer, the substrate including an organic material; a pixel circuit layer on the substrate in the first area and the second area, the pixel circuit layer being on the base layer in the bending area; and a display element layer on the pixel circuit layer. The pixel circuit layer may be directly on one surface of the base layer in the bending area.

The barrier layer and the substrate may not be in one area of the bending area (e.g., the one area of the bending area may be free of the barrier layer and the substrate or may not be in physical contact with the barrier layer and the substrate).

The pixel circuit layer may include a connection line of which at least a portion is on the base layer in the one area of the bending area.

The pixel circuit layer may further include a first insulating layer (e.g., a first electrically insulating layer), a second insulating layer (e.g., a second electrically insulating layer), a third insulating layer (e.g., a third electrically insulating layer), a fourth insulating layer (e.g., a fourth electrically insulating layer), a fifth insulating layer (e.g., a fifth electrically insulating layer), and a sixth insulating layer (e.g., a sixth electrically insulating layer), which are sequentially on the substrate. The fifth insulating layer and the sixth insulating layer may be commonly provided in the first area and the bending area. The connection line may be between the base layer and the fifth insulating layer in the one area of the bending area.

The display device may include a protective film on the display element layer in the bending area to cover the display element layer. The display element layer may include a pixel defining layer on the pixel circuit layer and a spacer on the pixel defining layer. The protective film may be on the spacer in the one area of the bending area.

The display element layer may include a pixel defining layer on the pixel circuit layer and a spacer on the pixel defining layer. The spacer may be in an uppermost layer in the one area of the bending area.

The first insulating layer and the second insulating layer may be on an end portion of the substrate to cover the end portion of the substrate in the first area adjacent to the bending area.

An end portion of the barrier layer may be more adjacent to the bending area than the end portion of the substrate.

The end portion of the substrate may be more adjacent to the bending area (e.g., may be closer to the bending area) than an end portion of the first and second insulating layers. The end portion of the first and second insulating layers may be more adjacent to the bending area (e.g., may be closer to the bending area) than an end portion of the third and fourth insulating layers.

The base layer may include a groove portion stepped toward a rear surface from one surface thereof. The groove portion may correspond to the bending area.

An end portion of the barrier layer and the end portion of the substrate may be located on the same line. The first insulating layer may be on the end portion of the substrate, the end portion of the barrier layer, and a portion of the groove portion to cover the end portion of the substrate, the end portion of the barrier layer, and the portion of the groove portion.

An end portion of the barrier layer may be on the same line as the end portion of the substrate. The first insulating layer and the second insulating layer may be on the end portion of the substrate, the end portion of the barrier layer, and one surface of the base layer.

The display device may include a dummy insulating pattern (e.g., a dummy electrically insulating patter) between the base layer and the connection line in the bending area. The dummy insulating pattern may include the same material as one of the first to fourth insulating layers, and be in the same layer as the one of the first to fourth insulating layers.

The third insulating layer may be on the second insulating layer on the end portion of the substrate.

The display device may include a dummy pattern between the fifth insulating layer and the sixth insulating layer in the bending area. The dummy pattern may be on the connection line with the fifth insulating layer interposed therebetween.

The display device may include an additional conductive line (e.g., an additional electrically conductive line) directly on the connection line in each of the bending area and at least one area of the first area.

The pixel circuit layer may further include a first insulating layer (e.g., a first electrically insulating layer), a second insulating layer (e.g., a second electrically insulating layer), a third insulating layer (e.g., a third electrically insulating layer), a fourth insulating layer (e.g., a fourth electrically insulating layer), a fifth insulating layer (e.g., a fifth electrically insulating layer), and a sixth insulating layer (e.g., a sixth electrically insulating layer), which are sequentially on the substrate. The fifth insulating layer and the sixth insulating layer may be commonly provided in the first area and the bending area. The connection line may be between the fifth insulating layer and the sixth insulating layer in the one area of the bending area.

The display device may include a dummy layer on one surface of the base layer in the bending area, the dummy layer including a second opening exposing a portion of the base layer. The dummy layer may include the same material as the substrate. The connection line may be on the one surface of the base layer, which is exposed by the second opening.

The pixel circuit layer may further include a first insulating layer (e.g., a first electrically insulating layer), a second insulating layer (e.g., a second electrically insulating layer), a third insulating layer (e.g., a third electrically insulating layer), a fourth insulating layer (e.g., a fourth electrically insulating layer), a fifth insulating layer (e.g., a fifth electrically insulating layer), and a sixth insulating layer (e.g., a sixth electrically insulating layer), which are sequentially on the substrate. The fifth insulating layer and the sixth insulating layer may be commonly provided in the first area and the bending area. The connection line may include a first connection line and a second connection line, which are provided in different layers. In the one area of the bending area, the first connection line may be between the base layer and the fifth insulating layer, and the second connection line may be between the fifth insulating layer and the sixth insulating layer.

A display device according to one or more embodiments includes a base layer including an organic material, in which a first flat area, a bending area continued to the first flat area, and a second flat area continued to the bending area are defined in the base layer; a barrier layer on the base layer in each of the first flat area and the second flat area; a substrate on the barrier layer, the substrate including the organic material; a pixel circuit layer on the substrate in the first flat area and the second flat area, the pixel circuit layer being on the barrier layer in the bending area; and a display element layer on the pixel circuit layer. The pixel circuit layer includes a connection line of which at least a portion is directly on one surface of the base layer in one area of the bending area, and wherein the barrier layer and the substrate are not in the one area of the bending area (e.g., the one area of the bending area may be free of the barrier layer and the substrate or may not be in physical contact with the barrier layer and the substrate).

An electronic device according to one or more embodiments includes a display device including a base layer comprising an organic material, in which a first area, a bending area continued to the first area, and a second area continued to the bending area are defined in the base layer; a barrier layer on the base layer in each of the first area and the second area; a substrate on the barrier layer, the substrate comprising an organic material; a pixel circuit layer on the substrate in the first area and the second area, the pixel circuit layer being on the base layer in the bending area; and a display element layer on the pixel circuit layer. The pixel circuit layer is directly on one surface of the base layer in the bending area.

The electronic device may be a television, a notebook computer, a monitor, an advertisement board, Internet of things (IOT) device, a mobile phone, a smartphone, a tablet personal computer (PC), an electronic watch, a smart watch, a watch phone, a head-mounted display, a mobile communication terminal, an electronic notebook, an electronic book, a portable multimedia player (PMP), a navigation system, a game device, a digital camera, or a camcorder.

At least some of the above and other features of the invention are set out in the claims.

### BRIEF DESCRIPTION OF THE DRAWINGS

Example embodiments of the present disclosure will now be described more fully hereinafter with reference to the accompanying drawings, however, the subject matter of the present disclosure may be embodied in different forms and should not be construed as limited to the embodiments set forth herein. Rather, these embodiments are provided so that this disclosure will be thorough and complete, and will fully convey the scope of the example embodiments to those skilled in the art.

In the drawing figures, dimensions may be exaggerated for clarity of illustration. It will be understood that when an element is referred to as being "between" two elements, it can be the only element between the two elements, or one or more intervening elements may also be present. Like reference numerals refer to like elements throughout.
FIG. 1 is a schematic perspective view illustrating a display device in accordance with one or more embodiments of the present disclosure.
FIG. 2 is a schematic perspective view illustrating a display device in accordance with one or more embodiments of the present disclosure.
FIG. 3 is a schematic plan view illustrating a display device in accordance with one or more embodiments of the present disclosure.
FIG. 4 is a schematic block diagram illustrating one or more embodiments of one of sub-pixels shown in FIG. 3.
FIG. 5 is a schematic plan view illustrating a pixel shown in FIG. 3.
FIG. 6 is a schematic cross-sectional view taken along line II-II' shown in FIG. 5.
FIG. 7 is a schematic perspective view illustrating a portion of the display device shown in FIG. 2.
FIG. 8 is a schematic cross-sectional view illustrating the display device shown in FIG. 7.
FIG. 9 is a schematic cross-sectional view illustrating a state of the display device shown in FIG. 8 before the display device is bent.
FIG. 10 is a schematic enlarged cross-sectional view of portion EA shown in FIG. 9.
FIGS. 11-12 are schematic cross-sectional views taken along line I-I' shown in FIG. 3.
FIG. 13 illustrates a portion of the display device in accordance with one or more embodiments of the present disclosure, and is a schematic cross-sectional view corresponding to the line I-I' shown in FIG. 3.
FIGS. 14-24 illustrate a portion of the display device in accordance with one or more embodiments of the present disclosure, and are schematic cross-sectional views corresponding to the portion EA shown in FIG. 9.
FIG. 25 is a block diagram of an electronic device according to an embodiment.
FIG. 26 shows schematic views of various embodiments of an electronic device.

### DETAILED DESCRIPTION

Embodiments of the present disclosure may apply various changes and different shapes, and therefore, the present disclosure only illustrates details with respect to example embodiments. However, the example embodiments are not limited to certain shapes but encompass all relevant changes and equivalent materials and replacements. The drawings included are illustrated in a fashion where the figures may be expanded for better understanding of the subject matter of the present disclosure.

Like numbers refer to like elements throughout. In the drawings, the thickness of certain lines, layers, components, elements or features may be exaggerated for clarity. It will be understood that, although the terms "first," "second," etc. may be used herein to describe various elements, these elements should not be limited by these terms. These terms are only used to distinguish one element from another element. Thus, a "first" element discussed below could also be termed a "second" element without departing from the teachings of the present disclosure. As used herein, the singular forms are intended to include the plural forms as well, unless the context clearly indicates otherwise.

It will be further understood that the terms "includes" and/or "including," when used in this specification, specify the presence of stated features, integers, steps, operations, elements, and/or components, but do not preclude the presence and/or addition of one or more other features, integers, steps, operations, elements, components, and/or groups thereof. Further, an expression that an element such as a layer, region, substrate or plate is placed "on" or "above" another element indicates not only a case where the element is placed "directly on" or "just above" the other element but also a case where a further element is interposed between the element and the other element. On the contrary, an expression that an element such as a layer, region, substrate or plate is placed "beneath" or "below" another element indicates not only a case where the element is placed "directly beneath" or "just below" the other element but also a case where a further element is interposed between the element and the other element.

Hereinafter, example embodiments of the present disclosure and items required for those skilled in the art to easily understand the content of the present disclosure will be described in more detail with reference to the accompanying drawings. In the following description, singular forms in the present disclosure are intended to include the plural forms as well, unless the context clearly indicates otherwise.

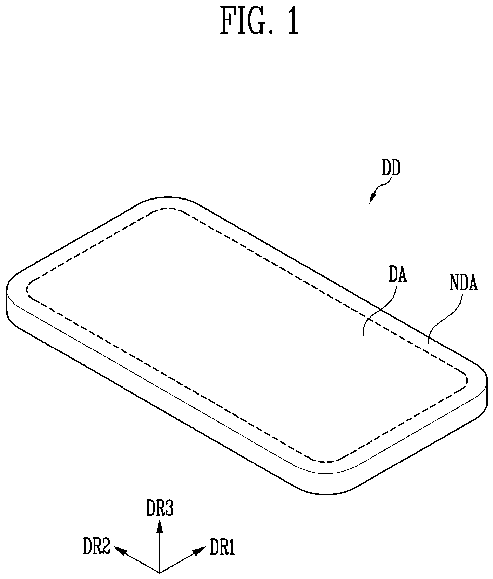

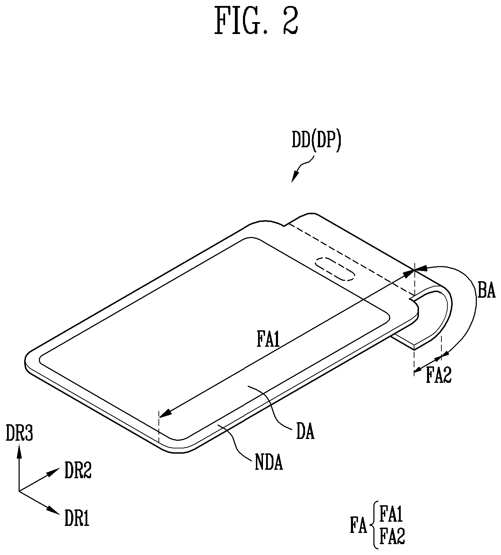

FIG. 1 is a schematic perspective view illustrating a display device DD in accordance with one or more embodiments of the present disclosure. FIG. 2 is a schematic perspective view illustrating a display device DD in accordance with one or more embodiments of the present disclosure.

Referring to FIGS. 1-2, the display device DD may display an image. The display device DD may refer to all electronic devices which provide display surfaces. For example, a television, a notebook computer, a monitor, an advertisement board, Internet of things (IOT) device, a mobile phone, a smartphone, a tablet personal computer (PC), an electronic watch, a smart watch, a watch phone, a head-mounted display, a mobile communication terminal, an electronic notebook, an electronic book, a portable multimedia player (PMP), a navigation system, a game device, a digital camera, a camcorder, and/or the like, which provide display surfaces, may be included in the display device DD, but the present disclosure is not limited thereto.

The display device DD may be a flat panel display device, a flexible display device, a curved display device, a foldable display device, a bendable display device, and/or a rollable display device. Also, the display device DD may be applied to a transparent display device, a head-mounted display device, a wearable display device, and/or the like.

The display device DD may include a display panel DP which provides a display surface. Examples of the display panel DP may include an inorganic light emitting diode display panel, an organic light emitting diode display panel, a quantum dot light emitting display panel, a plasma display panel, a field emission display panel, and the like, but the present disclosure is not limited thereto. Hereinafter, a case where an organic light emitting diode display panel is applied as an example of the display panel DP is disclosed. However, the present disclosure is not limited thereto, and another display panel may be applied as along as the same technical spirit is applicable.

The shape of the display device DD may be variously changed. For example, the display device DD may have various suitable shapes such as a rectangle, a square, a quadrangle having a round corner portion (or vertex), other polygons, and a circle. The shape of a display area DA of the display device DD may also be similar to the entire shape of the display device DD. In FIGS. 1-2, the display device DD and the display area DA, each of which has a quadrangular shape having a round corner portion, are provided as examples.

The display device DD may include the display area DA and a non-display area NDA. The display area DA may be an area in which an image can be displayed, and the non-display area NDA may be an area in which the image is not displayed (e.g., is not designed to be displayed). The display area DA may be referred to as an active area, and the non-display area NDA may be referred to as an inactive area. The display area DA may be provided in the middle of the display device DD, but the present disclosure is not limited thereto. The non-display area NDA may include a protrusion area that protrudes along at least one direction from a portion thereof. The protrusion area may protrude from sides constituting the non-display area NDA.

At least a portion of the display device DD may have flexibility, and the display device DD may be folded at the portion having the flexibility. In one or more embodiments, the term "being folded" does not mean that a shape is fixed but may inclusively mean that a shape is deformable into another shape from the original shape. The term "being folded" may include being folded along at least one set or specific line, e.g., a folding line, being curved, and/or being rolled like a roll.

The display device DD (or the display panel DP) may include a bending area BA which has flexibility and may be folded in at least one direction and a flat area FA which is not folded but flat while being continued to at least one side of the bending area BA. The flat area FA may be flexible or may be inflexible (e.g., may not be flexible).

Although it is illustrated that the bending area BA is provided in the non-display area NDA, the present disclosure is not limited thereto. In some embodiments, the bending area BA may be provided in the display area DA. The flat area FA may include a first flat area FA1 (or first area) and a second flat area FA2 (or second area), which are spaced apart from each other with the bending area BA interposed therebetween. The first flat area FA1 may be provided in the display area DA and at least a portion of the non-display area NDA. The bending area BA may be provided in the non-display area NDA while being continued to the first flat area FA1. The second flat area FA2 may be provided in the non-display area NDA while being continued to the bending area BA. The bending area BA and the second flat area FA2 may be provided in the protrusion area of the non-display area NDA.

The bending area BA may be provided in a folded state such that one surface of the first flat area FA1 and one surface of the second flat area FA2 face each other while being parallel (or substantially parallel) to each other, but the present disclosure is not limited thereto. In some embodiments, the bending area BA may be folded such that the surfaces of the first and second flat areas FA1 and FA2 form a set or predetermined angle (e.g., an acute angle, a right angle, or an obtuse angle) with the bending area BA interposed therebetween.

The protrusion area of the non-display area NDA may be subsequently bent (or folded) along a folding line. As the protrusion area of the non-display area NDA is bent (or folded), the width of a bezel can be reduced.

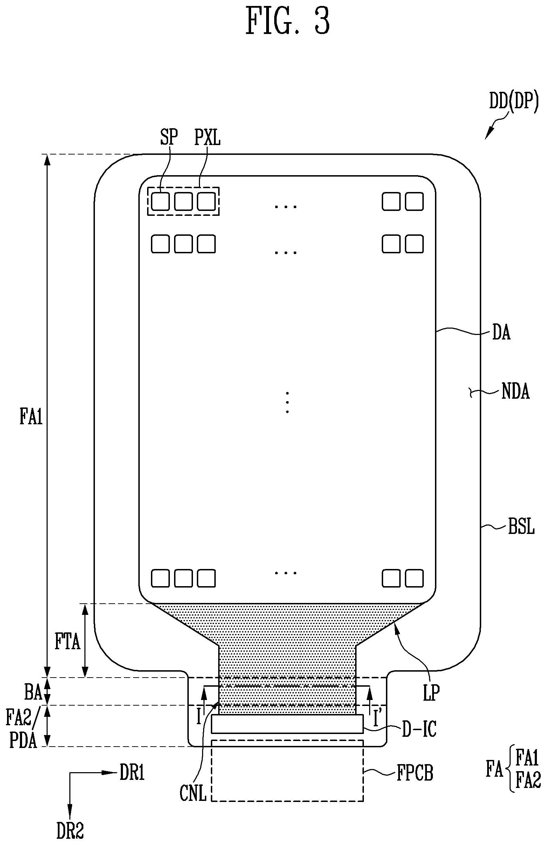

FIG. 3 is a schematic plan view illustrating a display device DD in accordance with one or more embodiments of the present disclosure. In FIG. 3, a structure of a display device DD, e.g., a display panel DP provided in the display device DD is illustrated, based on a display area DA in which an image is displayed.

Referring to FIG. 3, as a portion of a base layer BSL as a portion of the display device DD (or the display panel DP) is bent, a portion of the display device DD may have a bent shape like the base layer BSL.

The base layer BSL may include a first flat area FA1, a bending area BA, and a second flat area FA2, which are provided along a second direction DR2. The bending area BA may be between the first flat area FA1 and the second flat area FA2. The base layer BSL may be bent to have an equal or unequal curvature radius (e.g., a constant or substantially constant curvature radius) with respect to a bending axis.

The bending area BA may be provided while being continued to the first flat area FA1, and the second flat area FA2 may be provided while being continued to the bending area BA. The bending area BA may be integrally formed with the first flat area FA1 to be continued to the first flat area FA1, but the present disclosure is not limited thereto.

The base layer BSL may include various suitable materials having flexible and/or bendable characteristics. For example, the base layer BSL may include polymer resin such as polyethersulfone, polyacrylate, polyetherimide, polyethylene naphthalate, polyethylene terephthalate, polyphenylene sulfide, polyarylate, polyimide, polycarbonate, and/or cellulose acetate propionate.

The first flat area FA1 of the base layer BSL may include the display area DA and a non-display area NDA provided at the periphery of the display area DA.

Sub-pixels SP (or pixels) may be provided in the display area DA of the base layer BSL. Each sub-pixel SP may include at least one light emitting element. For example, the light emitting element may include a light emitting layer (e.g., an organic light emitting layer). A portion at which light is emitted by the light emitting element may be defined as an emission area. The display device DD may drive the sub-pixel SP, corresponding to image data, to thereby display an image in the display area DA.

The sub-pixels SP may be provided in the display area DA on the base layer BSL. The sub-pixels SP may be provided in a matrix form along a first direction DR1 and the second direction DR2 intersecting or crossing the first direction DR1, but the arrangement form of the sub-pixels SP is not limited thereto. For example, the sub-pixels SP may be provided in a zigzag form along the first direction DR1 and the second direction DR2. For example, the sub-pixels SP may be arranged in a PENTILE^{®} arrangement structure (e.g., an RGBG matrix, RGBG structure, or RGBG matrix structure), but the present disclosure is not limited thereto. PENTILE^{®} is a duly registered trademark of Samsung Display Co., Ltd. The first direction DR1 may be a row direction, and the second direction DR2 may be a column direction.

Two or more sub-pixels SP among the sub-pixels SP may constitute one pixel PXL.

The non-display area NDA of the base layer BSL may include a fan-out area FTA and a pad area PDA. At least one fan-out line LP may be provided in the fan-out area FTA, and a panel driver D-IC attached to a pad terminal may be provided in the pad area PDA. The panel driver D-IC may include a driving chip.

The panel driver D-IC may be connected to the pad terminal to be electrically connected to signal lines provided in the display area DA through the fan-out line LP and a connection line CNL. The pad area PDA in which the panel driver D-IC is provided may be between the display area DA and an area in which a flexible circuit board FPCB is attached. The flexible circuit board FPCB may be attached to an end portion of the second flat area FA2.

The fan-out line LP may be provided in the fan-out area FTA, and be connected to the connection line CNL of the bending area BA. The fan-out line LP may be electrically connected to a corresponding signal line provided in the display area DA through a separate connection member (e.g., a contact hole and/or the like).

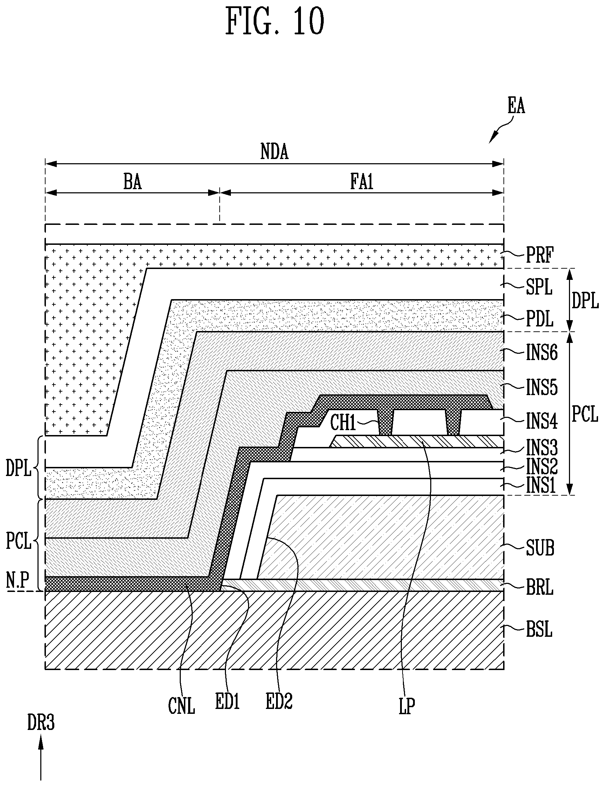

At least one connection line CNL may be provided in the bending area BA. The connection line CNL may extend from the first flat area FA1 to the second flat area FA2 via the bending area BA. The connection line CNL may be integrally formed with the fan-out line LP provided in the fan-out area FTA. For example, the fan-out line LP may be the connection line CNL. A protective film may be on the connection line CNL, and cracks of the connection line CNL may be prevented (or a likelihood, degree, or occurrence of such cracks may be reduced) due to the protective film. Components of the bending area BA will be further described herein with reference to FIG. 10.

The flexible circuit board FPBC may be attached to one side of the display panel DP. Components such as the flexible circuit board FPCB, which are unnecessary to be viewed by a user, may face a lower surface of the display panel DP, e.g., a surface on which no image is displayed in bending of the display panel DP.

The first direction DR1, the second direction DR2, and a third direction DR3 are illustrated in FIGS. 1-3 and the following drawings, and directions indicated by the first direction DR1, the second direction DR2, and the third direction DR3, which are described in this specification, are relative concepts, and may be changed into other directions. In this specification, the first direction DR1 and the second direction DR2 may be orthogonal to each other, and the third direction DR3 may be a normal direction with respect to a plane defined by the first direction DR1 and the second direction DR2. However, the present disclosure is not limited thereto.

A thickness direction of the display device DD may be a direction parallel (or substantially parallel) to the third direction DR3 as the normal direction with respect to the plane defined by the first direction DR1 and the second direction DR2.

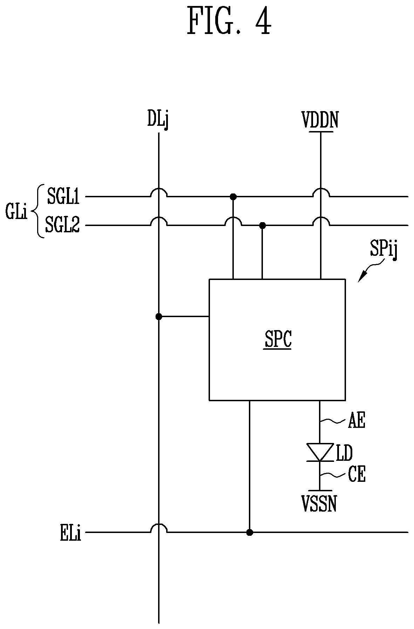

FIG. 4 is a schematic block diagram illustrating one or more embodiments of one of the sub-pixels shown in FIG. 3. In FIG. 4, a sub-pixel SPij arranged on an ith row and a jth column among the sub-pixels SP shown in FIG. 3 is illustrated as an example (i and j are integers of 1 or more).

Referring to FIGS. 3-4, the sub-pixel SPij may include a sub-pixel circuit SPC and a light emitting element LD.

The light emitting element LD may be connected between a first power voltage node VDDN and a second power voltage node VSSN. The first power voltage node VDDN may be a node that transfers a first power voltage, and the second power voltage node VSSN may be a node that transfers a second power voltage. The first power voltage may have a relatively high voltage level, and the second power voltage may have a voltage level lower than the voltage level of the first power voltage.

An anode electrode AE of the light emitting element LD may be connected to the first power voltage node VDDN through the sub-pixel circuit SPC, and a cathode electrode CE of the light emitting element LD may be connected to the second power voltage node VSSN. For example, the anode electrode AE of the light emitting element LD may be connected to the first power voltage node VDDN through one or more transistors included in the sub-pixel circuit SPC.

The sub-pixel circuit SPC may be electrically connected to signal lines. For example, the sub-pixel circuit SPC may be electrically connected to an ith gate line GLi among gate lines, an ith emission control line ELi among emission control lines, and a jth data line DLj among data lines. The sub-pixel circuit SPC may be configured to control the light emitting element LD according to signals received through these signal lines.

The sub-pixel circuit SPC may operate in response to a gate signal received through the ith gate line GLi. The ith gate line GLi may include one or more sub-gate lines. In one or more embodiments, as shown in FIG. 4, in the case that the ith gate line GLi includes two or more sub-gate lines, the sub-pixel circuit SPC may operate in response to gate signals received through the corresponding sub-gate lines.

The sub-pixel circuit SPC may operate in response to an emission control signal received through the ith emission control line ELi. In one or more embodiments, the ith emission control line ELi may include one or more sub-emission control lines. In the case that the ith emission control line ELi includes two or more sub-emission control lines, the sub-pixel circuit SPC may operate in response to emission control signals received through the corresponding emission control lines.

The sub-pixel circuit SPC may receive a data signal through the jth data line DLj. The sub-pixel circuit SPC may store a voltage corresponding to the data signal in response to at least one of the gate signals received through first and second sub-gate lines SGL1 and SGL2. The sub-pixel circuit SPC may control a current that flows from the first power voltage node VDDN to the second power voltage node VSSN through the light emitting element LD according to the stored voltage in response to the emission control signal received through the ith emission control line ELi. Accordingly, the light emitting element LD may generate (or emit) light having a luminance corresponding to the data signal.

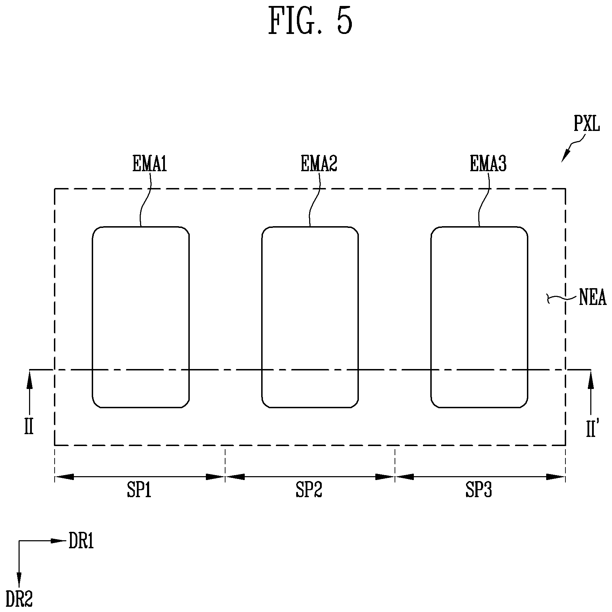

FIG. 5 is a schematic plan view illustrating the pixel PXL shown in FIG. 3.

Referring to FIGS. 3-5, the pixel PXL may include a first sub-pixel SP1, a second sub-pixel SP2, and a third sub-pixel SP3, which are provided in the first direction DR1.

The first sub-pixel SP1 may include a first emission area EMA1 and a non-emission area NEA at the periphery of the first emission area EMA1. The second sub-pixel SP2 may include a second emission area EMA2 and the non-emission area NEA at the periphery of the second emission area EMA2. The third sub-pixel SP3 may include a third emission area EMA3 and the non-emission area NEA at the periphery of the third emission area EMA3.

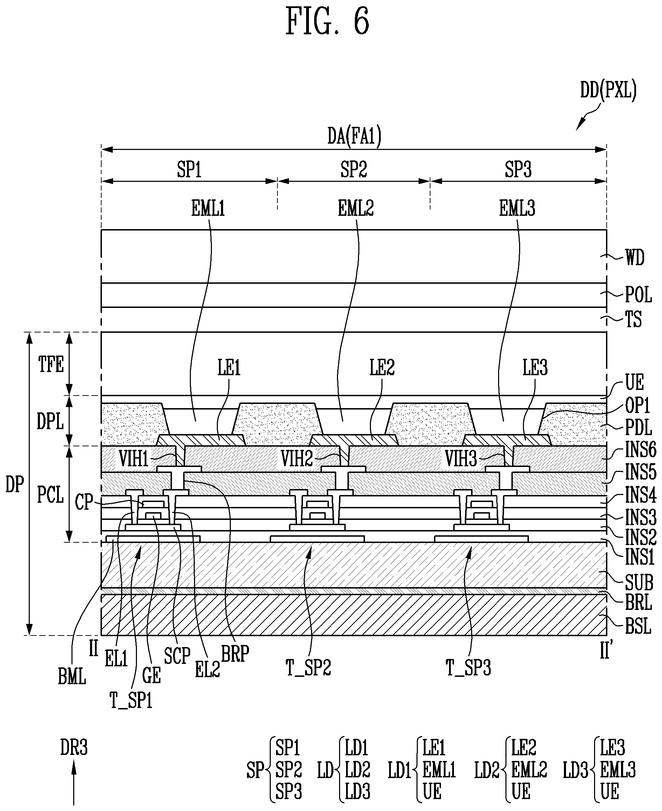

The first emission area EMA1 may be an area in which light is emitted from a light emitting layer corresponding to the first sub-pixel SP1. The second emission area EMA2 may be an area in which light is emitted from a light emitting layer corresponding to the second sub-pixel SP2. The third emission area EMA3 may be an area in which light is emitted from a light emitting layer corresponding to the third sub-pixel SP3. Each emission area may be understood as a first opening (see "OP1" shown in FIG. 6) of a pixel defining layer (see "PDL" shown in FIG. 6), which corresponds to each of the first to third sub-pixels SP1 to SP3.

The first sub-pixel SP1, the second sub-pixel SP2, and the third sub-pixel SP3 may substantially have the same area, but the present disclosure is not limited thereto. In some embodiments, the second sub-pixel SP2 may have an area larger than an area of the first sub-pixel SP1, and the third sub-pixel SP3 may have an area larger than the area of the second sub-pixel SP2.

The first sub-pixel SP1, the second sub-pixel SP2, and the third sub-pixel SP3 may each have a polygonal shape. For example, the first sub-pixel SP1, the second sub-pixel SP2, and the third sub-pixel SP3 may each have a polygonal shape (e.g., a hexagonal shape), but the present disclosure is not limited thereto. In some embodiments, the first sub-pixel SP1, the second sub-pixel SP2, and the third sub-pixel SP3 may each have a circular shape (or a generally circular shape), a semi-elliptical shape, and/or the like.

The arrangement of the sub-pixels shown in FIG 5 is merely illustrative, and embodiments are not limited thereto. Each pixel PXL may include two or more sub-pixels, and the sub-pixels may be provided in various suitable manners. Each of the sub-pixels may have various suitable shapes, and each of emission areas of the sub-pixels may also have various suitable shapes.

FIG. 6 is a schematic cross-sectional view taken along line II-II' shown in FIG. 5.

In FIG. 6, for convenience of description, a sectional structure (or stacked structure) of the display device DD is briefly illustrated based on the pixel PXL included in the display device DD, and a thickness direction of the base layer BSL (or a substrate SUB) is indicated as a third direction DR3.

Referring to FIGS. 5-6, the display device DD may include at least one pixel PXL in the display area DA. The pixel PXL may be provided in the display area DA of the first flat area FA1.

The pixel PXL may include at least one sub-pixel SP. For example, the pixel PXL may include a first sub-pixel SP1, a second sub-pixel SP2, and a third sub-pixel SP3. In one or more embodiments, the first sub-pixel SP1 may be a red sub-pixel, the second sub-pixel SP2 may be a green sub-pixel, and the third sub-pixel SP3 may be a blue sub-pixel. However, the present disclosure is not limited thereto. Hereinafter, in the case that the first sub-pixel SP1, the second sub-pixel SP2, and the third sub-pixel SP3 are inclusively designated, the first sub-pixel SP1, the second sub-pixel SP2, and the third sub-pixel SP3 are designated as a sub-pixel SP and/or sub-pixels SP.

Each of the first to third sub-pixels SP1 to SP3 may include the base layer BSL, the substrate SUB, a pixel circuit layer PCL, a display element layer DPL, a thin film encapsulation layer TFE, and a window WD.

The base layer BSL (or first substrate) may be made of polymer resin of a flexible material. For example, the base layer BSL may have a film form including one selected from the group consisting of a polyether-based polymer, a silicon-based polymer, an acrylic-based polymer, a polyolefin-based polymer, and copolymers thereof.

The substrate SUB (or second substrate) may be on one surface of the base layer BSL. The substrate SUB may include the same material as the base layer BSL. For example, the substrate SUB may be made of polymer resin of a flexible material. The substrate SUB may be provided in the first flat area FA1.

A barrier layer BRL may be between the base layer BSL and the substrate SUB. The barrier layer BRL may be, for example, an inorganic layer having a thin thickness, and include silicon oxide, silicon nitride, silicon oxynitride, amorphous silicon, crystalline silicon, aluminium oxide, and/or hafnium silicate. The barrier layer BRL may function to prevent or reduce infiltration or penetration of an impurity into a display unit including the pixel circuit layer PCL and the display element layer DPL through the base layer BSL and/or the substrate SUB.

The pixel circuit layer PCL may be on the substrate SUB in the first flat area FA1.

At least one insulating layer (e.g., electrically insulating layer) may be provided in the pixel circuit layer PCL. The insulating layer may include a first insulating layer INS1 (e.g., a first electrically insulating layer INS1), a second insulating layer INS2 (e.g., a second electrically insulating layer INS2), a third insulating layer INS3 (e.g., a third electrically insulating layer INS3), a fourth insulating layer INS4 (e.g., a fourth electrically insulating layer INS4), a fifth insulating layer INS5 (e.g., a fifth electrically insulating layer INS5), and a sixth insulating layer INS6 (e.g., a sixth electrically insulating layer INS6), which are sequentially stacked on one surface of the substrate SUB along the third direction DR3. The insulating layer provided in the pixel circuit layer PCL is not limited to the above-described embodiment. Another insulating layer (e.g., electrically insulating) may be added, or some insulating layers may be omitted.

The first insulating layer INS1 (or buffer layer) may be on the substrate SUB. The first insulating layer INS1 may prevent or reduce diffusion or penetration of an impurity into circuit elements (or driving elements), e.g., transistors, which constitute a sub-pixel circuit (see "SPC" shown in FIG. 4). The first insulating layer INS1 may be an inorganic layer including an inorganic material (or substance). The first insulating layer INS1 may include at least one of silicon nitride (SiNₓ), silicon oxide (SiOₓ), silicon oxynitride (SiOₓN_{y}), and aluminium oxide (AlOₓ). The first insulating layer INS1 may be provided as a single layer, but the present disclosure is not limited thereto and the first insulating layer INS1 may be provided as a multi-layer including at least two layers. The first insulating layer INS1 may be omitted according to a material of the substrate SUB, a process condition, and/or the like.

The second insulating layer INS2 (or barrier layer) may be on the first insulating layer INS1. The second insulating layer INS2 may include the same material as the first insulating layer INS1 or include a material suitable or appropriate (or selected) from the materials exemplified as the material constituting the first insulating layer INS1. For example, the second insulating layer INS2 may be an inorganic layer including an inorganic material.

The third insulating layer INS3 (or gate insulating layer) may be on the second insulating layer INS2. The third insulating layer INS3 may include the same material as the first insulating layer INS1 or include a material suitable or appropriate (or selected) from the materials exemplified as the material constituting the first insulating layer INS1.

The fourth insulating layer INS4 (or interlayer insulating layer) may be on the third insulating layer INS3. The fourth insulating layer INS4 may be an inorganic layer including an inorganic material and/or an organic layer including an organic material.

The fifth insulating layer INS5 (or first via layer) may be on the fourth insulating layer INS4. The fifth insulating layer INS5 may be an inorganic layer including an inorganic material and/or an organic layer including an organic material. The inorganic layer may include, for example, at least one selected from among silicon oxide (SiOₓ), silicon nitride (SiNₓ), silicon oxynitride (SiOₓN_{y}), and aluminium oxide (AlOₓ). The organic layer may include, for example, at least one selected from among acrylic resin, epoxy resin, phenolic resin, polyamide resin, polyimide resin, unsaturated polyester resin, poly-phenylene ether resin, poly-phenylene sulfide resin, and benzocyclobutene resin. In one or more embodiments, the fifth insulating layer INS5 may be an organic layer including an organic material.

The sixth insulating layer INS6 (or second via layer) may be on the fifth insulating layer INS5. The sixth insulating layer INS6 may include the same material as the fifth insulating layer INS5 or include a material suitable or appropriate (or selected) from the materials exemplified as the material constituting the fifth insulating layer INS5. For example, the sixth insulating layer INS6 may be an organic layer including an organic material.

The pixel circuit layer PCL may include one or more conductive layers (e.g., electrically conductive layers) between the above-described insulating layers. For example, the conductive layers may include a first conductive layer (e.g., a first electrically conductive layer) between the second insulating layer INS2 and the third insulating layer INS3, a second conductive layer (e.g., a second electrically conductive layer) between the third insulating layer INS3 and the fourth insulating layer INS4, a third conductive layer (e.g., a third electrically conductive layer) between the fourth insulating layer INS4 and the fifth insulating layer INS5, and a fourth conductive layer (e.g., a fourth electrically conductive layer) between the fifth insulating layer INS5 and the sixth insulating layer INS6. The insulating layers and the conductive layers are not limited to the above-described embodiment. In some embodiments, another insulating layer (e.g., another electrically insulating layer) and another conductive layer (e.g., another electrically conductive layer) in addition to the insulating layers and the conductive layers described above may be provided in the pixel circuit layer PCL.

Circuit elements (or driving elements) of each of the first to third sub-pixels SP1 to SP3 may be provided in the pixel circuit layer PCL. For example, a transistor T_SP1 of the first sub-pixel SP1, a transistor T_SP2 of the second sub-pixel SP2, and a transistor T_SP3 of the third sub-pixel SP3 may be provided in the pixel circuit layer PCL. The transistor T_SP1 of the first sub-pixel SP1 may be one of the transistors included in a sub-pixel circuit SPC of the first sub-pixel SP1, the transistor T_SP2 of the second sub-pixel SP2 may be one of the transistors included in a sub-pixel circuit SPC of the second sub-pixel SP2, and the transistor T_SP3 of the third sub-pixel SP3 may be one of the transistors included in a sub-pixel circuit SPC of the third sub-pixel SP3. In FIG. 6, for clear and brief description, one of the transistors of each sub-pixel SP is illustrated, and the other circuit elements are omitted.

The transistor T_SP1 of the first sub-pixel SP1 may include a semiconductor pattern SCP, a gate electrode GE, a first terminal EL1, and a second terminal EL2.

The gate electrode GE may be on the second insulating layer INS2 to be covered by the third insulating layer INS3. For example, the gate electrode GE may be the first conductive layer (or first gate conductive layer) between the second insulating layer INS2 and the third insulating layer INS3. The gate electrode GE may overlap with a portion of the semiconductor pattern SCP. For example, the gate electrode GE may overlap with an active pattern of the semiconductor pattern SCP.

The pixel circuit layer PCL may include a conductive pattern CP (e.g., an electrically conductive pattern CP) between the third insulating layer INS3 and the fourth insulating layer INS4. The conductive pattern CP may be configured with the second conductive layer (or second gate conductive layer). In some embodiments, the conductive pattern CP may overlap with the gate electrode GE with the third insulating layer INS3 interposed therebetween, thereby forming a capacitor.

The semiconductor pattern SCP may be on the first insulating layer INS1 to be covered by the second insulating layer INS2. The semiconductor pattern SCP may be a semiconductor layer made of poly-silicon, amorphous silicon, an oxide semiconductor, and/or the like. The semiconductor pattern SCP may include the active pattern, a first contact region, and a second contact region. The active pattern, the first contact region, and the second contact region may be configured with a semiconductor layer undoped with an impurity or doped with the impurity. For example, the first region and the second region may be configured with a semiconductor layer doped with the impurity, and the active pattern may be a region doped at a low concentration as compared with the first and second contact regions. Accordingly, a conductivity (e.g., electrical conductivity) of the first and second contact regions may be greater than a conductivity (e.g., electrical conductivity) of the active pattern. The first and second contact regions may be source/drain regions (or source/drain electrodes) of the transistor T_SP1 of the first sub-pixel SP1.

Because the active pattern of the semiconductor pattern SCP is a region that overlaps with the gate electrode GE, the active pattern may be a channel region. The first contact region of the semiconductor pattern SCP may be in contact with one end of the active pattern. The first contact region may be electrically connected to the first terminal EL1. The second contact region of the semiconductor pattern SCP may be in contact with the other end of the active pattern. The second contact region may be electrically connected to the second terminal EL2.

The first terminal EL1 may be provided and/or formed on the fourth insulating layer INS4. For example, the first terminal EL1 may be configured with the third conductive layer (or first source-drain conductive layer) between the fourth insulating layer INS4 and the fifth insulating layer INS5. The first terminal EL1 may be in contact with the first contact region of the semiconductor pattern SCP through a contact hole penetrating the fourth insulating layer INS4, the third insulating layer INS3, and the second insulating layer INS2.

The second terminal EL2 may be provided and/or formed on the fourth insulating layer INS4. The second terminal EL2 may be configured with the third conductive layer between the fourth insulating layer INS4 and the fifth insulating layer INS5. The second terminal EL2 may be in contact with the second contact region of the semiconductor pattern SCP through another contact hole penetrating the fourth insulating layer INS4, the third insulating layer INS3, and the second insulating layer INS2.

The second terminal EL2 may be electrically connected to a bridge pattern BRP on the fifth insulating layer INS5. The bridge pattern BRP may be the fourth conductive layer (or second source-drain conductive layer) between the fifth insulating layer INS5 and the sixth insulating layer INS6.

In some embodiments, a bottom metal pattern BML may be under the above-described transistor T_SP1 of the first sub-pixel SP1.

The bottom metal pattern BML may be a dummy conductive layer (e.g., a dummy electrically conductive layer) between the substrate SUB and the first insulating layer INS1. In some embodiments, the bottom metal pattern BML may be electrically connected to the transistor T_SP1 of the first sub-pixel SP1, to widen a driving range of a voltage supplied to the gate electrode GE.

As the gate electrode GE, the first terminal EL1, and the second terminal EL2 are electrically connected to other circuit elements and/or lines, the transistor T_SP1 of the first sub-pixel SP1 may be provided as one of the transistors constituting the sub-pixel circuit SPC of the first sub-pixel SP1.

Each of the transistor T_SP2 of the second sub-pixel SP2 and the transistor T_SP3 of the third sub-pixel SP3 may be configured to be substantially identical to the transistor T_SP1 of the first sub-pixel SP1.

As described above, the pixel circuit layer PCL may include circuit elements of each of the first to third sub-pixels SP1 to SP3.

The display element layer DPL may be on the pixel circuit layer PCL. The display element layer DPL may include a light emitting element LD and a pixel defining layer PDL. The light emitting element LD may include a lower electrode, a light emitting layer, and an upper electrode UE. The lower electrode may be the anode electrode AE described with reference to FIG. 4, and the upper electrode UE may be the cathode electrode CE described with reference to FIG. 4. The light emitting element LD may be provided in each of the first to third sub-pixels SP1 to SP3. The light emitting element LD provided in the first sub-pixel SP1 may be a first light emitting element LD1, the light emitting element LD provided in the second sub-pixel SP2 may be a second light emitting element LD2, and the light emitting element LD provided in the third sub-pixel SP3 may be a third light emitting element LD3.

A first lower electrode LE1 may be on the pixel circuit layer PCL (or the sixth insulating layer INS6) of the first sub-pixel SP1, a second lower electrode LE2 may be on the pixel circuit layer PCL (or the sixth insulating layer INS6) of the second sub-pixel SP2, and a third lower electrode CE3 may be on the pixel circuit layer PCL (or the sixth insulating layer INS6) of the third sub-pixel SP3. Each of the first to third lower electrodes LE1 to LE3 may be electrically connected to a circuit element provided in the pixel circuit layer PCL through a via hole that penetrates the sixth insulating layer INS6. For example, the first lower electrode LE1 may be electrically connected to the transistor T_SP1 of the first sub-pixel SP1 through a first via hole VIH1 that penetrates the sixth insulating layer INS6, the second lower electrode LE2 may be electrically connected to the transistor T_SP2 of the second sub-pixel SP2 through a second via hole VIH2 that penetrates the sixth insulating layer INS6, and the third lower electrode LE3 may be electrically connected to the transistor T_SP3 of the third sub-pixel SP3 through a third via hole VIH3 that penetrates the sixth insulating layer INS6.

In one or more embodiments, the first lower electrode LE1, the second lower electrode LE2, and the third lower electrode LE3 may correspond to the anode electrode AE. The first to third lower electrodes LE1 to LE3 may have shapes similar to shapes of the first to third emission areas EMA1 to EMA3 shown in FIG. 5 when viewed in the third direction DR3. For example, the first lower electrode LE1 may have a shape similar to the shape of the first emission area EMA1 when viewed in the third direction DR3, the second lower electrode LE2 may have a shape similar to the shape of the second emission area EMA2 when viewed in the third direction DR3, and the third lower electrode LE3 may have a shape similar to the shape of the third emission area EMA3 when viewed in the third direction DR3. However, the present disclosure is not limited thereto.

Each of the first to third lower electrodes LE1 to LE3 may be electrically connected to the sub-pixel circuit SPC to be supplied with a driving current. Each of the first to third lower electrodes LE1 to LE3 may include an opaque conductive (e.g., electrically conductive) material capable of reflecting light, but the present disclosure is not limited thereto. In some embodiments, the first to third lower electrodes LE1 to LE3 may include a transparent conductive (e.g., electrically conductive) material.

The pixel defining layer PDL may be on the first to third lower electrodes LE1 to LE3. The pixel defining layer PDL may include a first opening OP1 that exposes each of a portion of the first lower electrode LE1, a portion of the second lower electrode LE2, and a portion of the third lower electrode LE3. The pixel defining layer PDL may be a structure that defines (or partitions) the emission area of each of the first to third sub-pixels SP1 to SP3. For example, the pixel defining layer PDL may define the first emission area EMA1 of the first sub-pixel SP1, the second emission area EMA2 of the second sub-pixel SP2, and the third emission area EMA3 of the third sub-pixel SP3.

The pixel defining layer PDL may include an organic insulating layer including an organic material. The organic material (or organic substance) may include acrylic resin, epoxy resin, phenolic resin, polyamide resin, polyimide resin, and/or the like. In some embodiments, the pixel defining layer PDL may include a light absorption material or have a light absorber coated thereon, to absorb light introduced from the outside. For example, the pixel defining layer PDL may include a carbon-based black pigment. However, the present disclosure is not limited thereto.

A first light emitting layer EML1 may be on the first lower electrode LE1 exposed by a first opening OP1 of the pixel defining layer PDL, a second light emitting layer EML2 may be on the second lower electrode LE2 exposed by another first opening OP1 of the pixel defining layer PDL, and a third light emitting layer EML3 may be on the third lower electrode LE3 exposed by still another opening OP1 of the pixel defining layer PDL. Each of the first to third light emitting layers EML1, EML2, and EML3 may have a multi-layer structure including a hole injection layer, a hole transport layer, an organic light emitting layer, an electron transport layer, an electron injection layer, and/or the like.

The first to third light emitting layers EML1 to EML3 may include at least one of light emitting materials that emit lights of different colors according to a corresponding sub-pixel SP. For example, the first light emitting layer EML1 may include at least one of light emitting materials that emit red light, the second light emitting layer EML2 may include at least one of light emitting materials that emit green light, and the third light emitting layer EML3 may include at least one of light emitting materials that emit blue light. However, embodiments are not limited thereto. In some embodiments, in each of the first to third light emitting layers EML1 to EML3, a plurality of light emitting materials capable of generating light of different colors, such as red light, green light, and/or blue light, may be stacked, thereby to entirely emit white light. A color filter may be further on each of the first to third light emitting layers EML1 to EML3. The color filter may include at least one selected from among a red color filter, a green color filter, and a blue color filter.

The upper electrode UE may be on the first to third light emitting layers EML1 to EML3 and the pixel defining layer PDL. In one or more embodiments, the upper electrode UE may be the cathode electrode CE. The upper electrode UE may be a common layer commonly provided in the first to third sub-pixels SP1 to SP3. The upper electrode UE may be provided in a plate shape throughout the entire area of the display area DA. In some embodiments, the upper electrode UE may serve as a half mirror which allows light emitted from a corresponding light emitting layer to be partially transmitted therethrough and allows light emitted from the corresponding light emitting layer to be reflected therefrom.

The upper electrode UE may be a thin metal layer having a thickness to a degree to which light emitted from a corresponding light emitting layer can be transmitted therethrough. The upper electrode UE may be formed of a metal material to have a relatively thin thickness, or be formed of a transparent conductive (e.g., electrically conductive) material. In one or more embodiments, the upper electrode UE may include at least one selected from among various suitable transparent conductive materials including indium tin oxide, indium zinc oxide, indium tin zinc oxide, aluminium zinc oxide, gallium zinc oxide, zinc tin oxide, and gallium tin oxide. In another embodiment, the upper electrode UE may include at least one selected from among magnesium, silver, and mixtures thereof. However, the material of the upper electrode UE is not limited to the above-described embodiment.

The first lower electrode LE1, the first light emitting layer EML1, and a portion of the upper electrode UE, which overlaps with the first lower electrode LE1, may constitute the first light emitting element LD1. The second lower electrode LE2, the second light emitting layer EML2, and a portion of the upper electrode UE, which overlaps with the second lower electrode LE2, may constitute the second light emitting element LD2. The third lower electrode LE3, the third light emitting layer EML3, and a portion of the upper electrode UE, which overlaps with the third lower electrode LE3, may constitute the third light emitting element LD3.

The thin film encapsulation layer TFE may be on the upper electrode UE. The thin film encapsulation layer TFE may cover the upper electrode UE. The thin film encapsulation layer TFE may be configured to prevent or reduce infiltration or penetration of oxygen and/or moisture into the upper electrode UE. In one or more embodiments, the thin film encapsulation layer TFE may include a structure in which one or more inorganic layers and one or more organic layers are alternately stacked. For example, the inorganic layer may include silicon nitride, silicon oxide, silicon oxynitride, and/or the like. For example, the organic layer may include an organic insulating (e.g., electrically insulating) material such as acrylic resin, epoxy resin, a phenolic resin, polyamide resin, polyimide resin, unsaturated polyester resin, polyphenylenether resin, polyphenylenesulfide resin, and/or benzocyclobutene. However, the materials of the organic and inorganic layers of the thin film encapsulation layer TFE are not limited thereto.

A touch sensor layer TS may be on the thin film encapsulation layer TFE. The touch sensor layer TS may be directly on the thin film encapsulation layer TFE. In one or more embodiments, "being directly on" may exclude being attached using a separate adhesive layer, and mean being formed through a continuous process (e.g., may mean direct physical contact without any intervening materials therebetween). However, embodiments are not limited thereto.

The touch sensor layer TS may be on a surface on which an image is output to receive a touch input of a user. The touch sensor layer TS may recognize a touch event of the display device through a hand of the user, a separate input means, and/or the like. For example, the touch sensor layer TS may recognize a touch event, using a capacitive method.

The window WD may be on the touch sensor layer TS. The window WD may be a protective member on the top of the touch sensor layer TS to protect components of the display device DD. The window WD may be made of glass and/or plastic. In the case that the window WD is made of glass, Ultra Thin Glass (UTG) having a thickness of 0.1 mm or less may be applied to have flexible characteristics, but the present disclosure is not limited thereto. The window WD may have a thickness of approximately 385 µm along the third direction DR3, but the present disclosure is not limited thereto.

The display device DD may further include a polarizing layer POL between the touch sensor TS and the window WD. The polarizing layer POL may function to reduce external light reflection. For example, in the case that external light is reflected from a top surface of the upper electrode UE while passing through the polarizing layer POL and then again passes through the polarizing layer POL, the phase of the external light may be changed as the external light passes through the polarizing layer POL twice. As a result, the phase of reflected light becomes different from the phase of external light incident onto the polarizing layer POL, and as a result, destructive interference may occur. Consequently, external reflection is reduced, so that visibility can be improved. The polarizing layer POL may be coupled to the window WD, using an optical transparent adhesive member and/or the like.

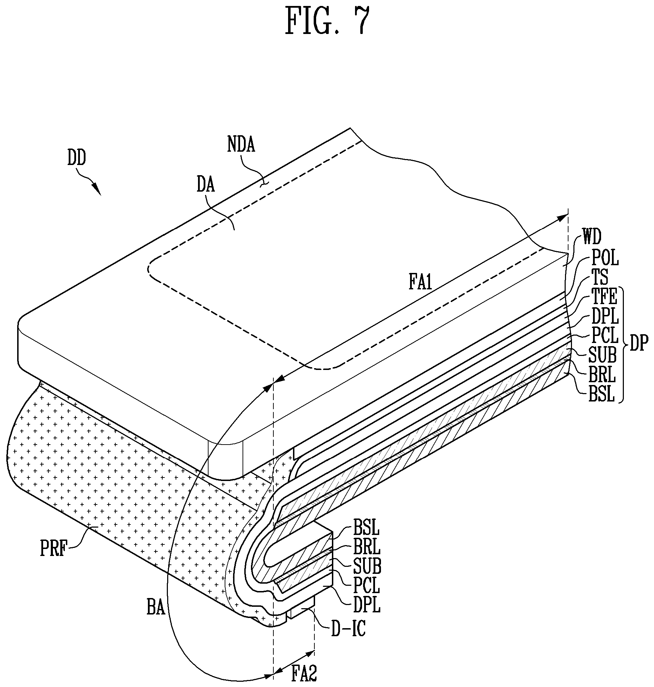

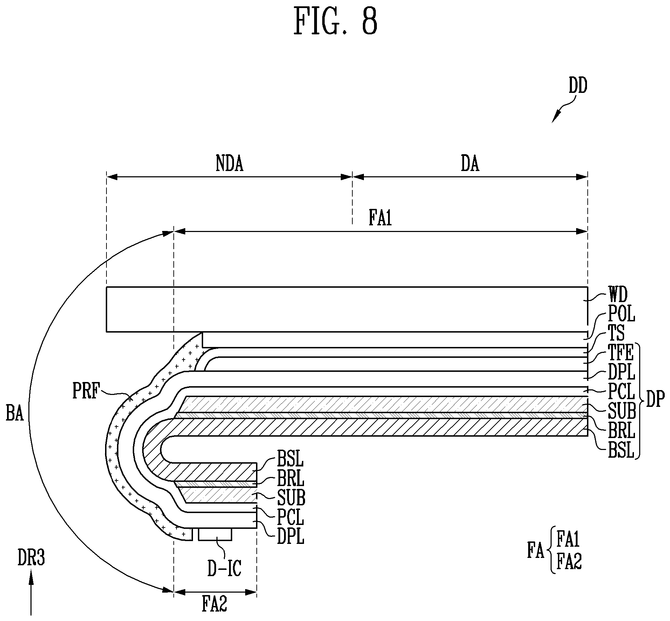

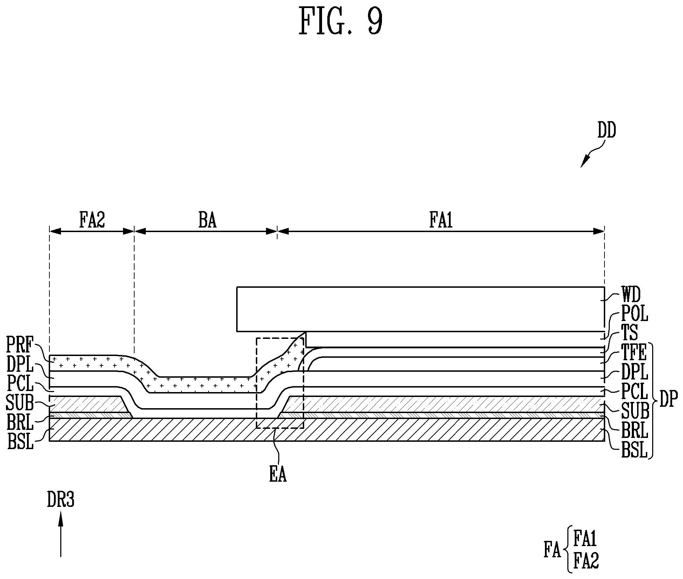

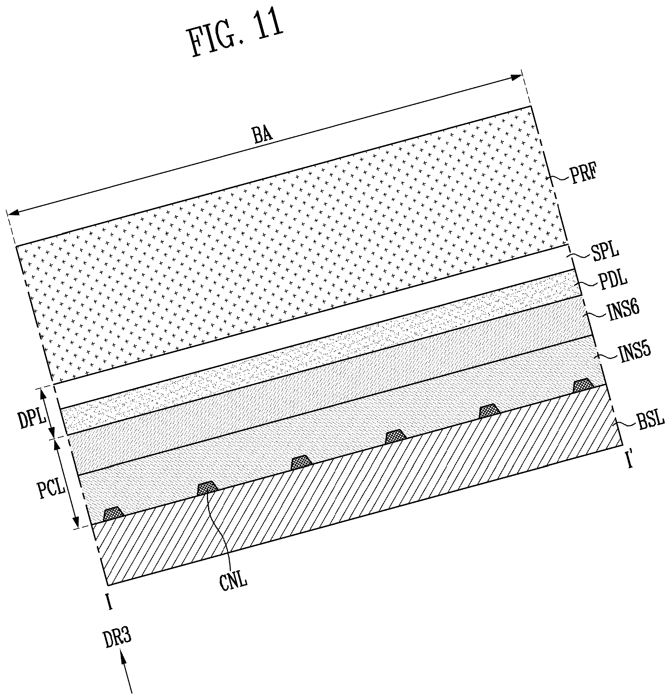

FIG. 7 is a schematic perspective view illustrating a portion of the display device DD shown in FIG. 2. FIG. 8 is a schematic cross-sectional view illustrating the display device DD shown in FIG. 7. FIG. 9 is a schematic cross-sectional view illustrating a state of the display device DD shown in FIG. 8 before the display device DD is bent. FIG. 10 is a schematic enlarged cross-sectional view of portion EA shown in FIG. 9. FIGS. 11-12 are schematic cross-sectional views taken along line I-I' shown in FIG. 3.

In FIGS. 7-12, portions different from the portions of the above-described embodiment will be mainly described to avoid redundancy.

Referring to FIG. 2 and FIGS. 7-12, the display device DD in accordance with the embodiment of the present disclosure may include a display panel DP, a touch sensor layer TS, and a window WD. The display panel DP may include a base layer BSL, a barrier layer BRL, a substrate SUB, a pixel circuit layer PCL, a display element layer DPL, and a thin film encapsulation layer TFE.

The display device DD may include a display area DA in which an image is displayed and a non-display area NDA in which the image is not displayed (or is not designed to display an image). Also, the display device DD may include a flat area FA and a bending area BA. The flat area FA and the bending area BA may be described with reference to the display panel DP. For example, the flat area FA and the bending area BA may be determined according to bending of the display panel DP.

The flat area FA may include the first flat area FA1 and the second flat area FA2 with the bending area BA interposed therebetween. The first flat area FA1 may correspond to the display area DA and at least a portion of the non-display area NDA. The bending area BA may correspond to the non-display area NDA, and the second flat area FA2 may correspond to the non-display area NDA.

The window WD may be provided to correspond to the first flat area FA1 and one area of the bending area BA, the touch sensor layer TS and some components of the display panel PD may be provided to correspond to only the first flat area FA1, and the other components of the display panel DP may be provided to correspond up to the bending area BA and the second flat area FA2.

The second flat area FA2 may face the first flat area FA1 with the bending area BA interposed therebetween in a state in which the display device DD is bent as shown in FIGS. 7-8. A panel driver D-IC may be provided in the second flat area FA2.

The base layer BSL may include the first flat area FA1, the bending area BA, and the second flat area FA2. For example, the base layer BSL may be commonly provided in the first flat area FA1, the bending area BA, and the second flat area FA2. The base layer BSL may include a polymer resin having flexible, bendable and/or rollable characteristics.

The barrier layer BRL, the substrate SUB, the pixel circuit layer PCL, the display element layer DPL, the thin film encapsulation layer TFE, the touch sensor layer TS, a polarizing layer POL, and the window WD may be sequentially on one surface of the base layer BSL of the first flat area FA1.

The barrier layer BRL, the substrate SUB, the pixel circuit layer PCL, and the display element layer DPL may be sequentially on one surface of the base layer BSL of the second flat area FA2. The panel driver D-IC may be on the display element layer DPL of the second flat area FA2.

The pixel circuit layer PCL, the display element layer DPL, and a protective film PRF may be on one surface of the base layer BSL of the bending area BA.

The thin film encapsulation layer TFE, the touch sensor layer TS, and the polarizing layer POL among the components provided in the first flat area FA1 may not be provided in the bending area BA and the second flat area FA2. For example, the thin film encapsulation layer TFE, the touch sensor layer TS, and the polarizing layer POL may be omitted in the bending area BA and the second flat area FA2. However, the present disclosure is not limited thereto. In some embodiments, at least one selected from among the thin film encapsulation layer TFE, the touch sensor layer TS, and the polarizing layer POL may be provided in the bending area BA and/or the second flat area FA2.

The barrier layer BRL and the substrate SUB among the components provided in the first flat area FA1 may not be provided in the bending area BA. A portion of the substrate SUB and a portion of the barrier layer BRL, which correspond to the bending area BA, may be removed by sequentially forming the barrier layer BRL and the substrate SUB on the base layer BSL in which the flat area FA and the bending area BA are defined and then performing a photolithography process using a mask. Accordingly, the barrier layer BRL and the substrate SUB may be omitted in the bending area BA. However, the present disclosure is not limited thereto. In some embodiments, the barrier layer BRL and the substrate SUB may be provided in only one area of the bending area, and may not be provided in the other area. For example, the barrier layer BRL and the substrate SUB is not provided at the center of the bending area BA, but may be provided at an edge of the bending area BA, which is adjacent to the flat area FA.

The pixel circuit layer PCL in the first flat area FA1 may include first to sixth insulating layers INS1 to INS6 (e.g., first to sixth electrically insulating layers INS1 to INS6) sequentially stacked from one surface of the substrate SUB.

The display element layer DPL in the first flat area FA1 may include a pixel defining layer PDL and a spacer SPL. The spacer SPL may be on the pixel defining layer PDL, and include the same material as the pixel defining layer PDL. For example, the spacer SPL may be an organic layer including an organic material (or substance). In some embodiments, the spacer SPL may be on the pixel defining layer PDL in the display area DA of the first flat area FA1. In some embodiments, the spacer SPL in the display area DA may maintain a distance between the display element layer DPL and the touch sensor layer TS.

Some components of the pixel circuit layer PCL of the first flat area FA1 may extend to the bending area BA. For example, the fifth insulating layer INS5 and the sixth insulating layer INS6, which include an organic material, among the first to sixth insulating layers INS1 to INS6 may extend to the bending area BA. The pixel defining layer PDL and the spacer SPL of the display element layer DPL of the first flat area FA1 may extend to the bending area BA. In some embodiments, the fifth insulating layer INS5, the sixth insulating layer INS6, the pixel defining layer PDL, and the spacer SPL may extend to the second flat area FA2.

In one or more embodiments, an end portion ED1 of the barrier layer BRL in one area of the first flat area FA1, which is adjacent to the bending area BA, may be provided more adjacent to (e.g., closer to) the bending area BA than an end portion ED2 of the substrate SUB. The first insulating layer INS1 and the second insulating layer INS2 may be on a top surface of the substrate SUB and the end portion of the substrate SUB, and the barrier layer BRL may be on a rear surface of the substrate SUB. Accordingly, the substrate SUB may be surrounded by the barrier layer BRL, the first insulating layer INS, and the second insulating layer INS2. In some embodiments, all the rear surface, the top surface and the end portion ED2 of the substrate SUB may be surrounded by the barrier layer BRL and the first and second insulating layers INS1 and INS2. The substrate SUB including an organic material such as polymer resin may be completely surrounded by the barrier layer BRL and the first and second insulating layers INS1 and INS2, which include an inorganic material, thereby block or reduce transmission of oxygen, moisture and/or the like, which may be introduced into the first flat area FA1 from the bending area BA, into the substrate SUB. Accordingly, it is omitted that a valley and/or the like is formed by removing a portion of an inorganic insulating layer so as to block or reduce introduction of moisture and/or oxygen in the bending area BA, so that the manufacturing efficiency of the display device DD can be improved.

The protective film PRF may be on the display element layer DPL (or the spacer SPL) of the bending area BA. The protective film PRF may be made of a polymer compound, and minimize or reduce occurrence of cracks due to stress applied to the components provided in the bending area BA in bending of the display device DD, thereby blocking or reducing propagation of the cracks. The protective film PRF may be on the display element layer DPL in at least one area selected from among the bending area BA and the second flat area FA2. Also, the protective film PRF may be on the display element layer DPL in at least one area of the first flat area FA1, which is adjacent to the bending area BA.

The pixel circuit layer PCL of the bending area BA may include at least one connection line CNL. The connection line CNL may be between the base layer BSL and the fifth insulating layer INS5 in the bending area BA. The connection line CNL may be configured with the third conductive layer (or first source-drain conductive layer) described with reference to FIG. 6. The connection layer CNL may be configured with a conductive layer (e.g., an electrically conductive layer) of a multi-layer including two or more layers. For example, the connection line CNL may be configured with a conductive layer (e.g., an electrically conductive layer) of a triple layer of Ti/Al/Ti.

The connection line CNL may be provided in the non-display area NDA of the first flat area FA1, which is adjacent to the bending area BA. The connection line CNL may be electrically connected to a corresponding fan-out line LP through a first contact hole CH1 that penetrates the fourth insulating layer INS4 in the non-display area NDA of the first flat area FA1. For example, the fan-out line LP may be configured with the second conductive layer (or second gate conductive layer) between the third insulating layer INS3 and the fourth insulating layer INS4.

The connection line CNL in the bending area BA may be between the one surface of the base layer BSL and the fifth insulating layer INS5, and the fifth insulating layer INS5, the sixth insulating layer INS6, the pixel defining layer PDL, the spacer SPL, and the protective film PRF may be on the top of the connection line CNL. As the connection line CNL in the bending area BA is directly on the one surface of the base layer BSL, the position of the connection line CNL may be adjacent to a rear surface of the base layer BSL. Therefore, in the case that the display device DD is bent in the bending area BA, a neutral plane N.P may be provided at or in the vicinity of a place where the connection line CNL is provided.

In accordance with the above-described embodiment, as some components, e.g., the barrier layer BRL and the substrate SUB, which are provided in the flat area FA, are omitted in the bending area BA, the connection line CNL may be directly on the one surface of the base layer BSL. The neutral plane N.P defined as a plane on which tensile stress and compressive stress are cancelled out may be provided close to the rear surface of the base layer BSL. Accordingly, the neutral plane N.P may move to a lower portion of the display device DD (or the display panel DP).

The fifth insulating layer INS5 and the sixth insulating layer INS6, which include an organic material (or substance), the pixel defining layer PDL, and the spacer SPL may be sequentially on the connection layer CNL, to prevent or reduce application of excessive stress to the connection line CNL in bending of the display device DD, thereby preventing cracks of connection line CNL (or reducing a likelihood, degree, or occurrence of such cracks). As the fifth insulating layer INS5 and the sixth insulating layer INS6, which include the organic material, the pixel defining layer PDL, and the spacer SPL are on the connection line CNL in the bending area BA, the thickness of the protective film PRF provided to block or reduce occurrence of cracks in the connection line CNL in the bending area BA can become thin. For example, in the above-described embodiment, the thickness of the protective film PRF provided in an uppermost layer in the bending area BA can be decreased. An increase in dead space of the display device DD due to the thickness of the protective film PRF can be prevented or reduced.

In the above-described embodiment, as the barrier layer BRL and the substrate SUB, which are provided in the flat area FA, are omitted in the bending area BA, a thickness of the display panel DP in the bending area BA can become thinner than a thickness of the display panel DP in the first flat area FA1. A dead space can be decreased corresponding to a degree to which the thickness of the display panel DP in the bending area becomes thin (e.g., the thickness is reduced).

Also, in the above-described embodiment, the connection line CNL is on the one surface of the base layer BSL in the bending area BA, so that the neutral plane N.P can be provided between the base layer BSL and the connection line CNL. Ascension of the neutral plane N.P is prevented or reduced as the thickness of the display panel DP in the bending area BA becomes thin by inducing descent of the neutral plane N.P, so that the probability that cracks will occur in the connection line CNL can be minimized or reduced.

In some embodiments, some insulating layers (e.g., electrically insulating layers) among the first to fourth insulating layers INS1 to INS4 or all the first to fourth insulating layers INS1 to INS4 may be omitted between the substrate SUB and the connection line CNL in one area of the first flat area FA1, which is adjacent to the bending area BA. The structure of the one area of the first flat area FA1, which is adjacent to the bending area BA, may be simplified.

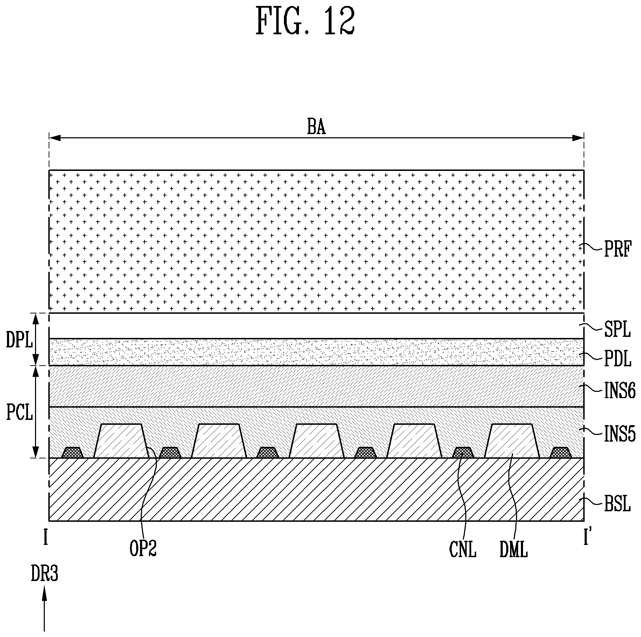

In some embodiments, a dummy layer DML for enhancing the mechanical strength of the display panel DP may be provided in the bending area BA as shown in FIG. 12. The dummy layer DML may be on the one surface of the base layer BSL, and be patterned to include a second opening OP2 that exposes a portion of the base layer BSL such that bending is facilitated without (or substantially without) occurrence of cracks. The dummy layer DML may include polymer resin. For example, the dummy layer DML may include the same material as the substrate SUB provided in the first flat area FA1.

A connection line CNL may be on the one surface of the base layer BSL, which is exposed by the second opening OP2 of the dummy layer DML. The connection line CNL and the dummy layer DML may be spaced apart from each other at a set or certain distance.

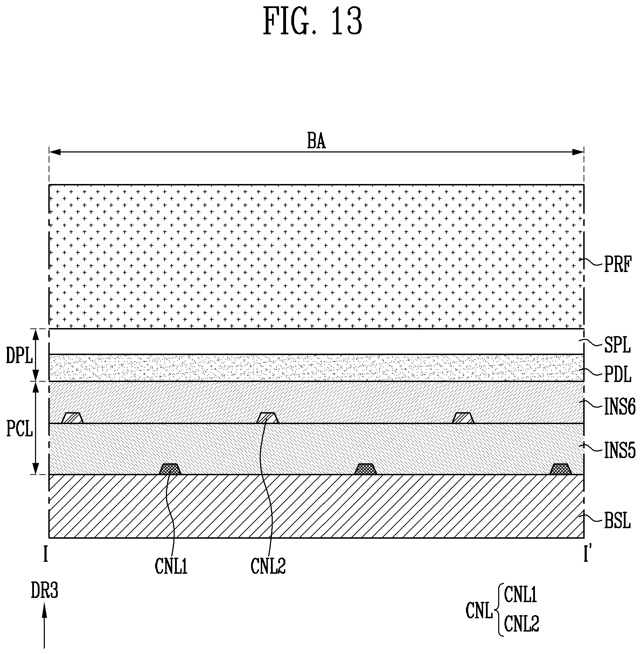

FIG. 13 illustrates a portion of the display device in accordance with one or more embodiments of the present disclosure, and is a schematic cross-sectional view corresponding to the line I-I' shown in FIG. 3.

Referring to FIGS. 3 and 13, the connection line CNL may include a first connection line CNL1 and a second connection line CNL2, which are provided in different layers. The first connection line CNL1 may be configured with the third conductive layer (or first source-drain conductive layer), and the second connection line CNL2 may be configured with the fourth conductive layer (or second source-drain conductive layer).

In the bending area BA, the first connection line CNL1 may be between the base layer BSL and the fifth insulating layer INS5, and the second connection line CNL2 may be between the fifth insulating layer INS5 and the sixth insulating layer INS6. The first connection line CNL1 and the second connection line CNL2 may be alternately provided in the bending area BA. The first connection line CNL1 and the second connection line CNL2 may be electrically separated from each other (e.g., electrically insulated from each other). Each of the first and second connection lines CNL1 and CNL2 may be electrically connected to a signal line provided in the display area DA through a corresponding fan-out line LP.

As described above, as the connection line CNL in the bending area BA includes the first connection line CNL1 and the second connection line CNL2, which are provided in different layers, the size of the bending area BA in which the connection line CNL is provided is decreased, so that a dead space of the display device DD can be reduced.

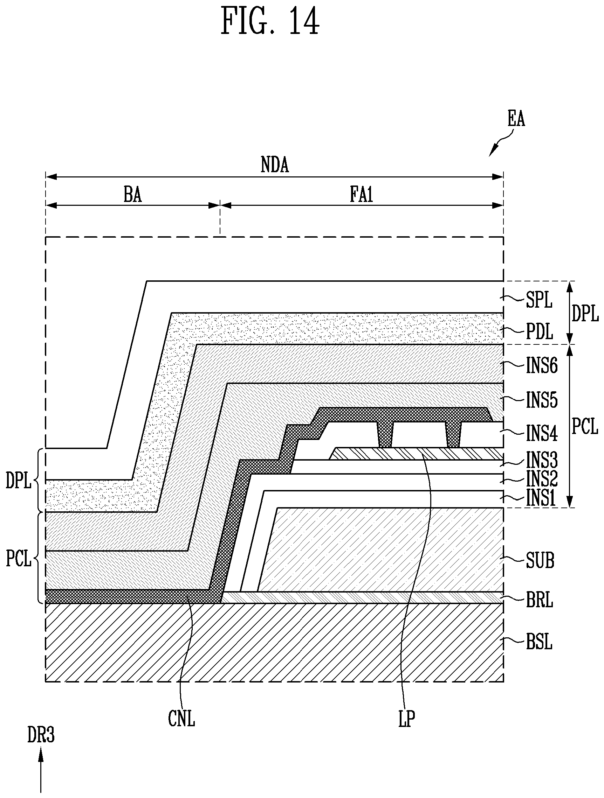

FIGS. 14-24 illustrate a portion of the display device in accordance with one or more embodiments of the present disclosure, and are schematic cross-sectional views corresponding to the portion EA shown in FIG. 9.

In FIGS. 14-24, portions different from the portions of the above-described embodiment will be mainly described to avoid redundancy.

Referring to FIGS. 9 and 14, the connection line CNL in the bending area BA may be between the one surface of the base layer BSL and the fifth insulating layer INS5 of the pixel circuit layer PCL. The fifth insulating layer INS5, the sixth insulating layer INS6, the pixel defining layer PDL, and the spacer SPL may be on the connection line CNL.

The fifth insulating layer INS5 and the sixth insulating layer INS6, which include an organic material (or substance), the pixel defining layer PDL, and the spacer SPL may be sequentially on the connection layer CNL, to prevent or reduce application of excessive stress to the connection line CNL in bending of the display device DD, thereby preventing cracks of connection line CNL (or reducing a likelihood, degree, or occurrence of such cracks). Accordingly, the protective film (see "PRF" shown in FIG. 10) provided to prevent or reduce formation of cracks of the connection line CNL may be omitted. The spacer SPL of the display element layer DPL may be provided in an uppermost layer in the bending area BA. As the protective film PRF is omitted, the thickness of the display panel DP in the bending area BA can become thinner. Accordingly, an increase in dead space of the display device DD due to the thickness of the protective film PRF can be prevented or reduced.

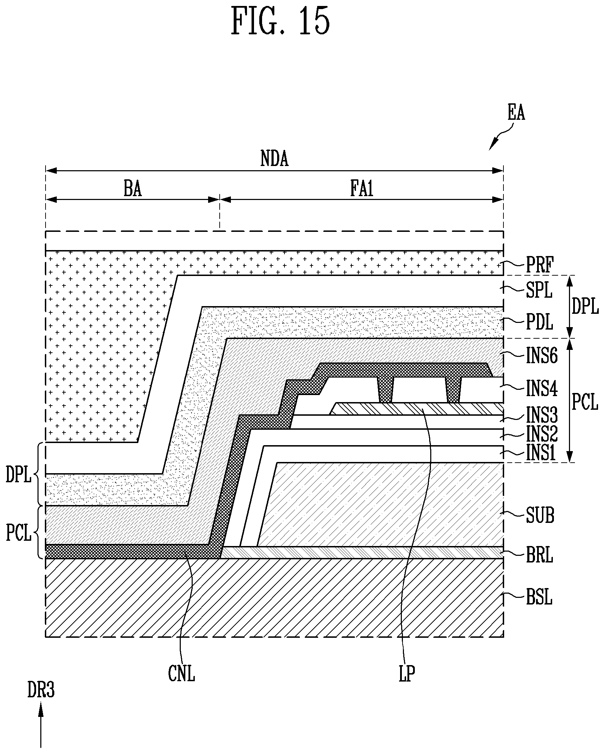

Referring to FIGS. 9 and 15, the sixth insulating layer INS6 including an organic material, the pixel defining layer PDL, the spacer SPL, and the protective film PRF may be sequentially on the connection line CNL in the bending area BA and one area of the first flat area FA1, which is adjacent to the bending area BA. The connection line CNL in the bending area BA may be between the one surface of the base layer BSL and the sixth insulating layer INS6.

The sixth insulating layer INS6, the pixel defining layer PDL, the spacer SPL, and the protective film PRF are sequentially on the connection line CNL, to prevent or reduce application of excessive stress to the connection line CNL in bending of the display device DD, thereby preventing cracks of connection line CNL (or reducing a likelihood, degree, or occurrence of such cracks). As described above, the fifth insulating layer (see "INS5" shown in FIG. 13) is not on the connection line CNL but may be omitted. As the fifth insulating layer INS5 is omitted, the thickness of the display panel DP in the bending area BA can become thinner.

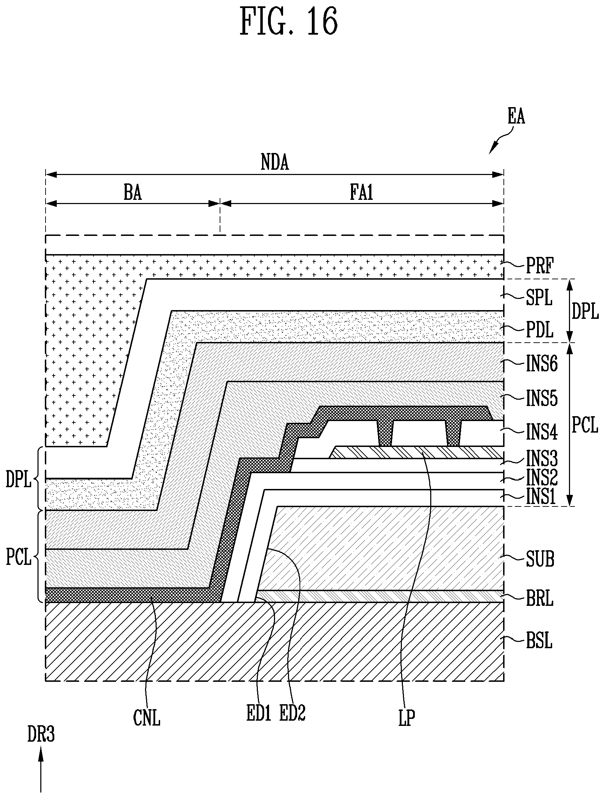

Referring to FIG. 9 and 16, the end portion ED1 of the barrier layer BRL provided in the first flat area FA1 adjacent to the bending area BA and the end portion ED2 of the substrate SUB on the barrier layer BRL may be on the same line along a direction inclined with respect to the third direction DR3. For example, as the end portion ED1 of the barrier layer BRL may move inward to be adjacent to the display area DA of the first flat area FA1, the end portion ED1 of the barrier layer BRL may be on the same line as the end portion ED2 of the substrate SUB. The first and second insulating layers INS1 and INS2 including an inorganic material may be on the end portion ED1 of the barrier layer BRL and the end portion ED2 of the substrate SUB. The end portion ED1 of the barrier layer BRL and the end portion ED2 of the substrate SUB may be surrounded by the first and second insulating layers INS1 and INS2. Accordingly, the substrate SUB including an organic material may be surrounded by the barrier layer BRL and the first and second insulating layers INS1 and INS2, which include an inorganic material. Thus, introduction of external oxygen, moisture and/or the like into the substrate SUB may be prevented or reduced.

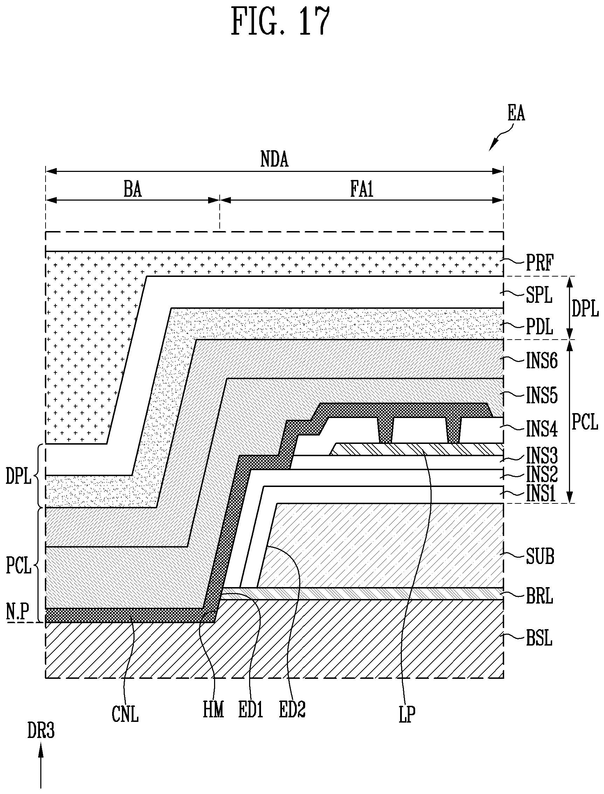

Referring to FIGS. 9 and 17, the base layer BSL may include a groove portion HM corresponding to the bending area BA. The groove portion HM may be an area stepped in a direction from the one surface (e.g., an upper surface) of the base layer BSL to the other surface (e.g., a lower surface) of the base layer BSL. The base layer BSL including the groove portion HM may have a thickness thinner than a thickness of the base layer BSL in the first flat area FA1, which does not include the groove portion HM.

As the base layer BSL includes the groove portion HM in the bending area BA, the connection line CNL may be provided at the groove portion HM of the base layer BSL. Accordingly, the neutral plane N.P may be between the groove portion HM of the base layer BSL and the connection line CNL. Ascension of the neutral plane N.P is prevented or reduced as the thickness of the display panel DP in the bending area BA becomes thin, so that the probability that cracks will occur in the connection line CNL can be further minimized or reduced.

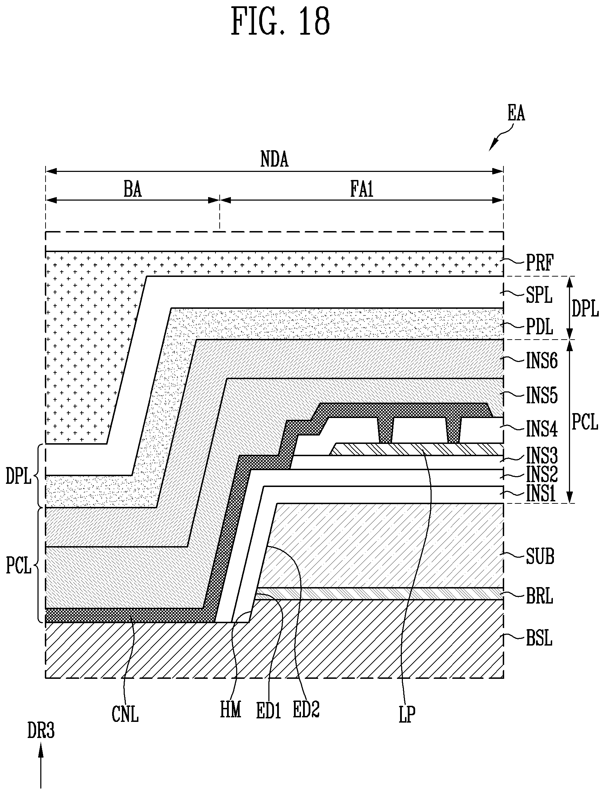

Referring to FIGS. 9 and 18, the end portion ED1 of the barrier layer BRL and the end portion ED2 of the substrate SUB, which are provided in the first flat area FA1 adjacent to the bending area BA, may be on the same line along a direction inclined with respect to the third direction DR3. Also, the end portion ED1 of the barrier layer BRL and the end portion ED2 of the substrate SUB may be on the same line as a start point of the groove portion HM of the base layer BSL. The start point of the groove portion HM may mean a point at which a step difference is started in the base layer BSL.

After the barrier layer BRL and the substrate SUB are sequentially formed on the base layer BSL, the substrate SUB provided in the bending area BA may be removed through a photolithography process using a mask, thereby exposing the barrier layer BRL under the substrate SUB. The barrier layer BRL exposed in the bending area BA may be removed through an etching process using the substrate remaining in the first flat area FA1 as an etching mask, thereby exposing one area of the base layer BSL. A portion of the base layer BSL exposed in the bending area BA may be removed through an additional photolithography process using a mask, thereby forming the groove portion HM. Through the above-described process, the end portion ED2 of the substrate SUB adjacent to the bending area BA, the end portion ED1 of the barrier layer BRL under the substrate SUB, and the start point of the groove portion HM of the base layer BSL may be on the same line along a direction inclined with respect to the third direction DR3.

In one or more embodiments, the start point of the groove portion HM of the base layer BSL, the end portion ED1 of the barrier layer BSL, and the end portion ED2 of the substrate SUB may be surrounded by the first and second insulating layers including an inorganic material. Introduction of oxygen, moisture, and/or the like into the substrate SUB may be blocked or reduced.

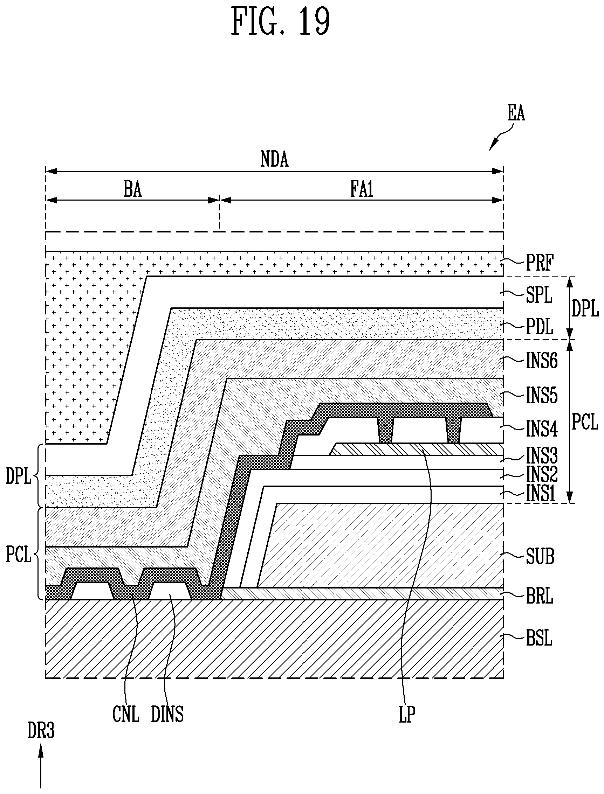

Referring to FIGS. 9 and 19, a dummy insulating pattern DINS (e.g., a dummy electrically insulating pattern DINS) may be provided in the bending area BA. The dummy insulating pattern DINS may be between the one surface of the base layer BSL and the connection line CNL. The dummy insulating pattern DINS may be between the base layer BSL and the connection line CNL, to reinforce adhesion between the base layer including an inorganic material and the connection line CNL including a conductive material (e.g., an electrically conductive material).

The dummy insulating pattern DINS may include the same material as one of the first to third insulating layers INS1 to INS3 of the pixel circuit layer PCL provided in the first flat area FA1. For example, the dummy insulating pattern DINS may be formed through the same process as the first insulating layer INS1 (or buffer layer), to be provided in the same layer as the first insulating layer INS1 and include the same material as the first insulating layer INS1. However, embodiments are not limited thereto. In some embodiments, the dummy insulating pattern DINS may be formed through the same process as one of the second to fourth insulating layers INS2 to INS4, to include the same material as the one of the second to fourth insulating layers INS2 to INS4.

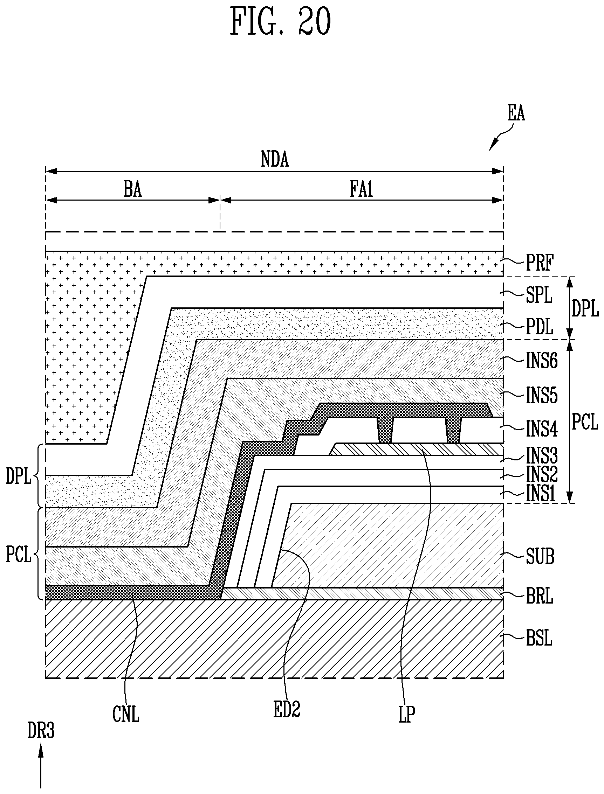

Referring to FIGS. 9 and 20, the first insulating layer INS1, the second insulating layer INS2, and the third insulating layer INS3 may be on the end portion ED2 of the substrate SUB in the first flat area FA1 adjacent to the bending area BA. Therefore, the top surface, the end portion ED2 (or a side surface), and the rear surface of the substrate SUB including an organic material may be completely surrounded by the barrier layer BRL and the first to third insulating layers INS1 to INS3, which include an inorganic material. Accordingly, introduction of oxygen, moisture and/or the like into the substrate SUB, which may be introduced into the first flat area FA1 from the bending area BA, may be blocked or reduced.

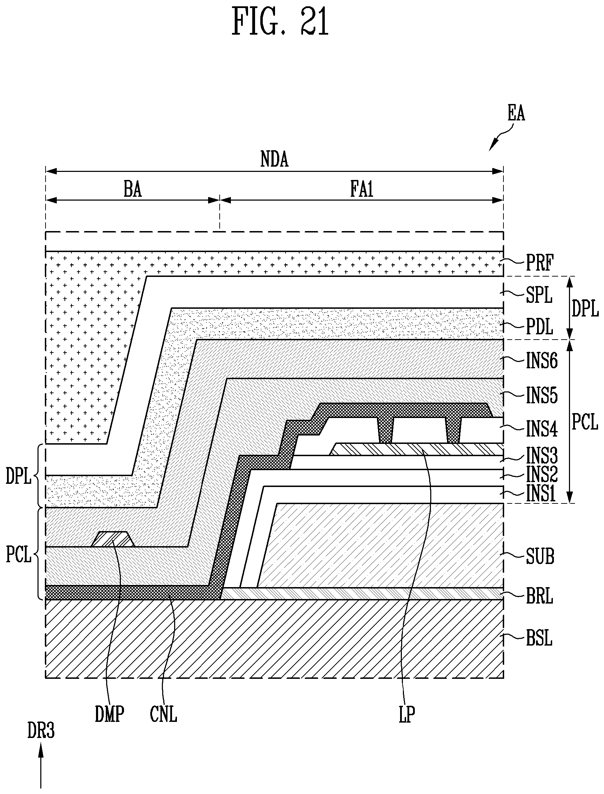

Referring to FIGS. 9 and 21, at least one dummy pattern DMP may be provided in the bending area BA. The dummy pattern DMP may be configured with the fourth conductive layer (or second source-drain conductive layer) between the fifth insulating layer INS5 and the sixth insulating layer INS6. The dummy pattern DMP may be on the connection line CNL with the fifth insulating layer INS5 interposed therebetween, and be electrically separated from (e.g., electrically insulated from) the connection line CNL.

The dummy pattern DMP may be a reinforcing member which prevents or reduces excessive application of stress to the connection line CNL in bending of the display panel DP, thereby ensuring or enhancing the mechanical strength of the display device DD.

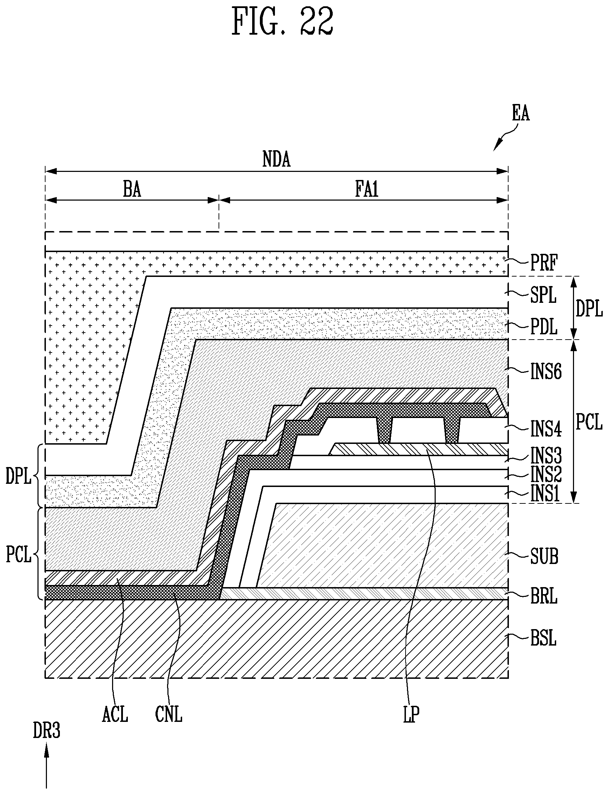

Referring to FIGS. 9 and 22, an additional conductive line ACL (e.g., an additional electrically conductive line ACL) may be on the connection line CNL. The additional conductive line ACL may be configured with the fourth conductive layer (or second source-drain conductive layer), and be covered by the sixth insulating layer INS6. The additional conductive line ACL may be directly on the connection line CNL to be electrically and physically connected to the connection line CNL. Any suitable insulating layer (e.g., the fifth insulating layer (see "INS5" shown in FIG. 21) may not be between the connection line CNL and the additional conductive line ACL.

The connection line CNL may be electrically connected to the additional conductive line ACL provided thereon, to be implemented in a double-layer structure. Accordingly, the line resistance (e.g., the electrical line resistance) of the connection line CNL can be reduced.

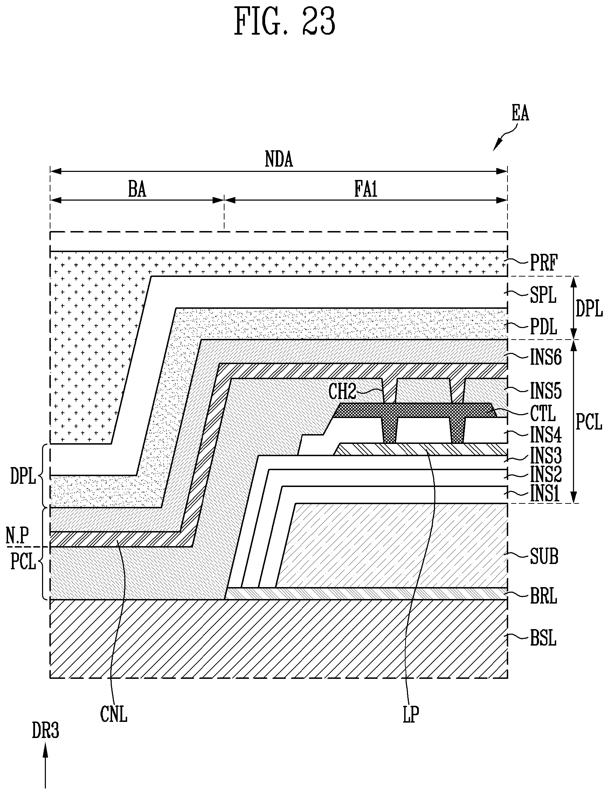

Referring to FIGS. 9 and 23, the connection line CNL may be configured with the fourth conductive layer (or second source-drain conductive layer) between the fifth insulating layer INS5 and the sixth insulating layer INS6.

The connection line CNL may be electrically connected to a corresponding fan-out line LP through an intermediate layer CTL. The intermediate layer CTL may be configured with the third conductive layer (or first source-drain conductive layer) between the fourth insulating layer INS4 and the fifth insulating layer INS5 in the first flat area FA1. The connection line CNL may be electrically connected to the intermediate layer CTL through a second contact hole CH2 that penetrates the fifth insulating layer INS5. The intermediate layer CTL may be on the fourth insulating layer INS4 in one area of the first flat area FA1, which is adjacent to the bending area BA.

The connection line CNL may be between the fifth insulating layer INS5 and the sixth insulating layer INS6 in the bending area BA, and the sixth insulating layer INS6, the pixel defining layer PDL, the spacer SPL, and the protective film PRF may be on the connection line CNL. As the connection line CNL is on the fifth insulating layer INS5 on the base layer BSL in the bending area BA, the neutral plane N.P may be between the fifth insulating layer INS5 and the connection line CNL. The neutral plane N.P may move to a lower portion of the display device DD (or the display panel DP) as compared with the existing display device in which a component provided in the bending area BA is identical to a component provided in the flat area FA. Accordingly, ascension of the neutral plane N.P is prevented or reduced, thereby reducing the probability that cracks will occur in the connection line CNL.

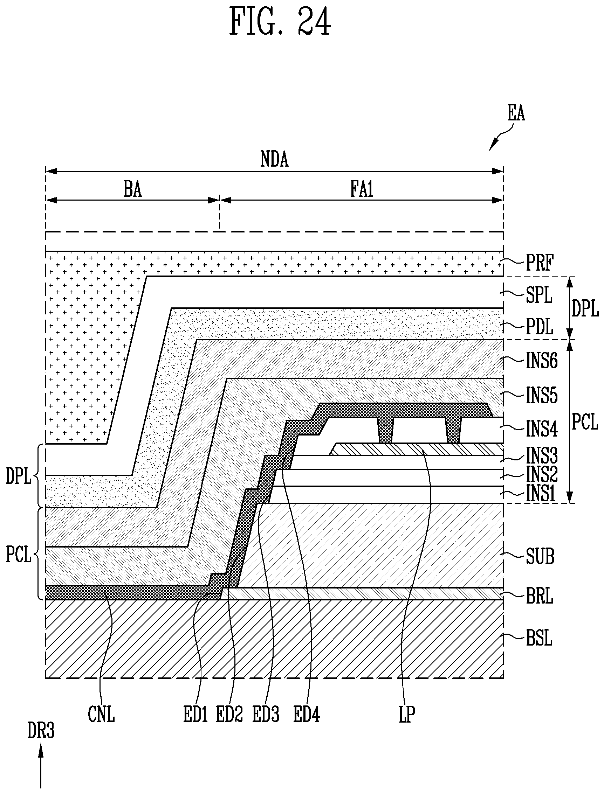

Referring to FIGS. 9 and 24, the end portion ED1 of the barrier layer BRL in the first flat area FA1 adjacent to the bending area BA may be more adjacent to (e.g., closer to) the bending area BA than the end portion ED2 of the substrate SUB, the end portion ED2 of the substrate SUB may be more adjacent to (e.g., closer to) the bending area BA than an end portion ED3 of the first and second insulating layers INS1 and INS2, and the end portion ED3 of the first and second insulating layers INS1 and INS2 may be more adjacent to (e.g., closer to) the bending area BA than an end portion ED4 of the third and fourth insulating layers INS3 and INS4. Accordingly, in a plan view, the end portion ED1 of the barrier layer BRL, the end portion ED2 of the substrate SUB, the end portion ED3 of the first and second insulating layers INS1 and INS2 and the end portion ED4 of the third and fourth insulating layers INS3 and INS4 may have a stepped shape.

In one or more embodiments, the connection line CNL may be on the end portion ED1 of the barrier layer BRL, the end portion ED2 of the substrate SUB, the end portion ED3 of the first and second insulating layers INS1 and INS2 and the end portion ED4 of the third and fourth insulating layers INS3 and INS4 to cover the end portion ED1 of the barrier layer BRL, the end portion ED2 of the substrate SUB, the end portion ED3 of the first and second insulating layers INS1 and INS2 and the end portion ED4 of the third and fourth insulating layers INS3 and INS4. Accordingly, the end portion ED1 of the barrier layer BRL, the end portion ED2 of the substrate SUB, the end portion ED3 of the first and second insulating layers INS1 and INS2 and the end portion ED4 of the third and fourth insulating layers INS3 and INS4 may not be exposed to the outside.

Before the connection line CNL is formed, the barrier layer BRL, the substrate SUB, and the first to fourth insulating layers INS1 to INS4 may be sequentially formed on the base layer BSL. The end portion ED4 of the third and fourth insulating layers INS3 and INS4, the end portion ED3 of the first and second insulating layers INS1 and INS2, and the end portion ED2 of the substrate SUB may be sequentially formed through a photolithography process using a mask. For example, as a portion of the substrate SUB is removed in the bending area BA after the first to fourth insulating layers INS1 to INS4 on the substrate SUB are patterned, the end portion ED2 of the substrate SUB may be exposed to the outside.

In the case that the pixel circuit layer PCL is formed after the substrate SUB is formed on the base layer BSL and the barrier layer BRL, and a portion of the substrate SUB, which corresponds to the bending area BA, is removed through a photolithography process using a mask, a semiconductor layer, a conductive layer (e.g., an electrically conductive layer), and/or the like among the components included in the pixel circuit layer PCL may be deposited on the end portion ED2 of the substrate SUB. As the semiconductor layer and the conductive layer, which are deposited on the end portion ED2 of the substrate SUB, are not completely removed while a subsequent process is performed, the semiconductor layer and the conductive layer may remain on the end portion ED2 of the substrate SUB. As the end ED2 of the substrate SUB is not completely covered by insulating layers (e.g., electrically insulating layers), e.g., the first and second insulating layers INS1 and INS2, which include an inorganic material, oxygen, moisture, and/or the like may be introduced into the substrate SUB from the outside.

Accordingly, in the above-described embodiment, the end portion ED2 of the present disclosure is exposed by forming the substrate SUB on the base layer BSL and the barrier layer BRL, finally forming the first to fourth insulating layers INS1 to INS4 on the substrate SUB, and then removing a portion of the substrate SUB, which corresponds to the bending area BA, so that a defect which may occur as a semiconductor layer, a conductive layer (e.g., an electrically conductive layer), and the like remain on the end portion ED2 of the substrate SUB can be prevented (or a likelihood, degree, or occurrence of such a defect may be reduced).

In accordance with embodiments of the present disclosure, there can be provided a display device in which the thickness of a bending area is reduced by omitting a barrier layer and a substrate in the bending area, so that a dead space caused by the bending area can be reduced.

In accordance with embodiments of the present disclosure, there can be provided a display device in which the position of a neutral plane is moved to a lower portion of a display panel by provided lines of a bending area to be adjacent to a barrier layer, so that the dead space caused by the bending area can be further reduced.

In accordance with embodiments of the present disclosure, there can be provided a display device in which the strength of a bending area is enhanced, so that cracks of lines in a bending area are prevented (or a likelihood, degree, or occurrence of such cracks is reduced), thereby improving the reliability of the display device.

A display device according to an embodiment is applicable to various types of electronic devices. In an embodiment, an electronic device includes the above-described display device and may further include other modules or devices having additional functions in addition to the display device.

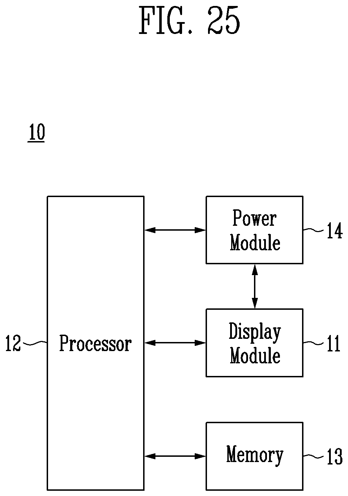

FIG. 25 is a block diagram of an electronic device according to an embodiment. Referring to FIG. 25, the electronic device 10 may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), and a controller.

The memory 13 may store data and/or information used to operate the processor 12 or the display module 11. When the processor 12 executes an application stored in the memory 13, image data signals and/or input control signals may be transferred to the display module 11. The display module 11 may process the provided signals and output image information on a display screen.

The power module 14 may include a power supply module, such as a power adapter or a battery device, and a power conversion module. The power conversion module converts power supplied by the power supply module and generates power to operate the electronic device 10.

At least one of the above-described components of the electronic device 10 may be included in the display device according to embodiments as described above. In addition, in terms of functionality, some of the individual modules included in one module may be included in the display device and others may be provided separately from the display device. For example, the display module 11 is included in the display device, whereas the processor 12, the memory 13, and the power module 14 are not included in the display device and are instead provided separately in the electronic device 10.

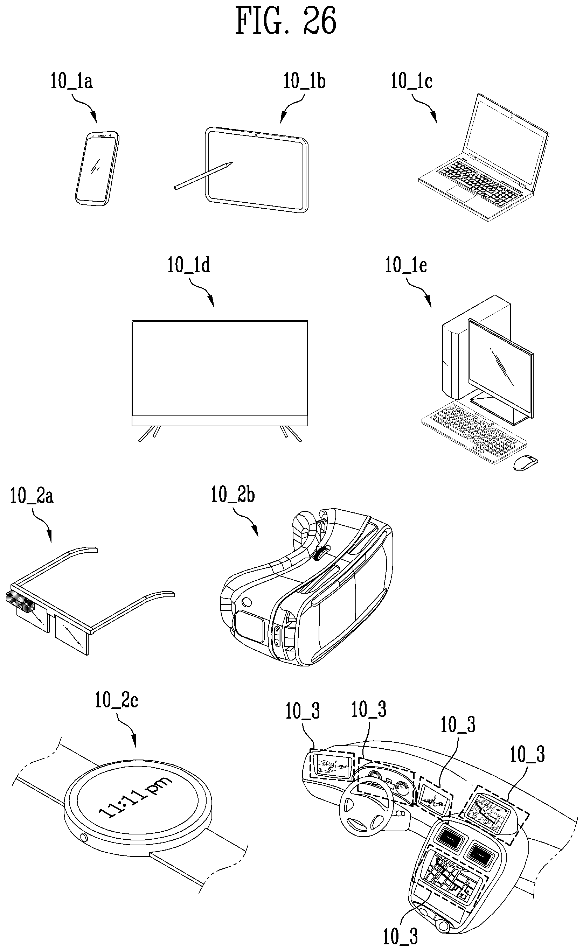

FIG. 26 shows schematic views of various embodiments of an electronic device.

Referring to FIG. 26, various types of electronic devices to which embodiments of a display device are applied may include an electronic device to display images such as a smartphone 10_1a, a tablet PC 10_1b, a laptop computer 10_1c, a television (TV) 10_1d, and a desktop monitor 10_1e, a wearable electronic device including a display module such as smart glasses 10_2a, a head-mounted display (HMD) 10_2b, and a smart watch 10_2c, and an automotive electronic device 10_3 including a display module such as a center information display (CID) disposed at the instrument cluster, the center fascia, and the dashboard of a vehicle, and a room mirror display.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various suitable changes in form and details may be made without departing from the scope of embodiments of the present disclosure as set forth in the following claims, and equivalents thereof.

## Claims

1. A display device (DD) comprising:
a base layer (BSL) comprising an organic material, in which a first area, a bending area (BA) continued to the first area, and a second area continued to the bending area (BA) are defined in the base layer (BSL);
a barrier layer (BRL) on the base layer (BSL) in each of the first area and the second area;
a substrate (SUB) on the barrier layer (BRL), the substrate (SUB) comprising an organic material;
a pixel circuit layer (PCL) on the substrate (SUB) in the first area and the second area, the pixel circuit layer (PCL) being on the base layer (BSL) in the bending area (BA); and
a display element layer (DPL) on the pixel circuit layer (PCL),
wherein the pixel circuit layer (PCL) is directly on one surface of the base layer (BSL) in the bending area (BA).

2. The display device (DD) as claimed in claim 1, wherein the barrier layer (BRL) and the substrate (SUB) are not in one area of the bending area (BA).

3. The display device (DD) as claimed in claim 1 or claim 2, wherein the pixel circuit layer (PCL) comprises a connection line (CNL) of which at least a portion is on the base layer (BSL) in the one area of the bending area (BA).

4. The display device (DD) as claimed in claim 3, wherein the pixel circuit layer (PCL) further comprises a first insulating layer (INS1), a second insulating layer (INS2), a third insulating layer (INS3), a fourth insulating layer (INS4), a fifth insulating layer (INS5), and a sixth insulating layer (INS6), which are disposed on the substrate (SUB),
wherein the fifth insulating layer (INS5) and the sixth insulating layer (INS6) are commonly provided in the first area and the bending area (BA), and
wherein the connection line (CNL) is between the base layer (BSL) and the fifth insulating layer (INS5) in the one area of the bending area (BA).

5. The display device (DD) as claimed in claim 4, wherein:
(i) the display device (DD) comprises a protective film (PRF) on the display element layer (DPL) in the bending area (BA) to cover the display element layer (DPL),
wherein the display element layer (DPL) comprises a pixel defining layer (PDL) on the pixel circuit layer (PCL) and a spacer (SPL) on the pixel defining layer (PDL), and
wherein the protective film (PRF) is on the spacer (SPL) in the one area of the bending area (BA); or
(ii) the display element layer (DPL) comprises a pixel defining layer (PDL) on the pixel circuit layer (PCL) and a spacer (SPL) on the pixel defining layer (PDL), and
wherein the spacer (SPL) is provided in an uppermost layer in the one area of the bending area (BA).

6. The display device (DD) as claimed in claim 4, wherein the first insulating layer (INS1) and the second insulating layer (INS2) are on an end portion of the substrate (SUB) to cover the end portion of the substrate (SUB) in the first area adjacent to the bending area (BA).

7. The display device (DD) as claimed in claim 6, wherein an end portion of the barrier layer (BRL) is more adjacent to the bending area (BA) than the end portion of the substrate (SUB), optionally wherein the end portion of the substrate (SUB) is more adjacent to the bending area (BA) than an end portion of the first and second insulating layers (INS1, INS2), and
wherein the end portion of the first and second insulating layers (INS1, INS2) is more adjacent to the bending area (BA) than an end portion of the third and fourth insulating layers (INS3, INS4).

8. The display device (DD) as claimed in claim 6, wherein the base layer (BSL) includes a groove portion (HM) stepped toward a rear surface from one surface thereof, and
wherein the groove portion (HM) corresponds to the bending area (BA), optionally wherein an end portion of the barrier layer (BRL) and the end portion of the substrate (SUB) are on the same line, and
wherein the first insulating layer (INS1) is on the end portion of the substrate (SUB), the end portion of the barrier layer (BRL), and a portion of the groove portion (HM) to cover the end portion of the substrate (SUB), the end portion of the barrier layer (BRL), and the portion of the groove portion (HM).

9. The display device (DD) as claimed in claim 6, wherein an end portion of the barrier layer (BRL) is on the same line as the end portion of the substrate (SUB), and
wherein the first insulating layer (INS1) and the second insulating layer (INS2) are on the end portion of the substrate (SUB), the end portion of the barrier layer (BRL), and one surface of the base layer (BSL).

10. The display device (DD) as claimed in claim 6, wherein:
(i) the display device (DD) comprises a dummy insulating pattern (DINS) between the base layer (BSL) and the connection line (CNL) in the bending area (BA), and
wherein the dummy insulating pattern (DINS) comprises the same material as one of the first to fourth insulating layers (INS1, INS2, INS3, INS4), and is provided in the same layer as the one of the first to fourth insulating layers (INS1, INS2, INS3, INS4); or
(ii) the third insulating layer (INS3) is on the second insulating layer (INS2) on the end portion of the substrate (SUB).

11. The display device (DD) as claimed in claim 6, wherein:
(i) the display device (DD) comprises a dummy pattern (DMP) between the fifth insulating layer (INS5) and the sixth insulating layer (INS6) in the bending area (BA), and
wherein the dummy pattern (DMP) is on the connection line (CNL) with the fifth insulating layer (INS5) interposed therebetween; or
(ii) the display device (DD) comprises an additional conductive line (ACL) directly on the connection line (CNL) in each of the bending area (BA) and at least one area of the first area.

12. The display device (DD) as claimed in claim 3, wherein the pixel circuit layer (PCL) further comprises a first insulating layer (INS1), a second insulating layer (INS2), a third insulating layer (INS3), a fourth insulating layer (INS4), a fifth insulating layer (INS5), and a sixth insulating layer (INS6), which are sequentially on the substrate (SUB),
wherein the fifth insulating layer (INS5) and the sixth insulating layer (INS6) are commonly provided in the first area and the bending area (BA), and
wherein the connection line (CNL) is between the fifth insulating layer (INS5) and the sixth insulating layer (INS6) in the one area of the bending area (BA).

13. The display device (DD) as claimed in any one of claims 3 to 12, wherein the display device (DD) comprises a dummy layer (DML) on one surface of the base layer (BSL) in the bending area (BA), the dummy layer (DML) having an opening (OP2) that exposes a portion of the base layer (BSL),
wherein the dummy layer (DML) comprises the same material as the substrate (SUB), and
wherein the connection line (CNL) is on the one surface of the base layer (BSL), which is exposed by the opening (OP2).

14. A display device (DD) comprising:
a base layer (BSL) comprising an organic material, in which a first flat area (FA1), a bending area (BA) continued to the first flat area (FA1), and a second flat area (FA2) continued to the bending area (BA) are defined in the base layer (BSL);
a barrier layer (BRL) on the base layer (BSL) in each of the first flat area (FA1) and the second flat area (FA2);
a substrate (SUB) on the barrier layer (BRL), the substrate (SUB) comprising the organic material;
a pixel circuit layer (PCL) on the substrate (SUB) in the first flat area (FA1) and the second flat area (FA2), the pixel circuit layer (PCL) being on the barrier layer (BRL) in the bending area (BA); and
a display element layer (DPL) on the pixel circuit layer (PCL),
wherein the pixel circuit layer (PCL) comprises a connection line (CNL) of which at least a portion is directly on one surface of the base layer (BSL) in one area of the bending area (BA), and
wherein the barrier layer (BRL) and the substrate (SUB) are not in the one area of the bending area (BA).

15. An electronic device (10) comprising:
a display device (DD) according to any one of claims 1 to 14.
